# EUROPEAN PATENT APPLICATION

(11) **EP 3 432 071 A1**
(43) Date of publication of application: **23.01.2019**
(21) Application number: 17181716.6
(22) Date of filing: 17.07.2017
(51) Int. Cl.: G03F 7/20, G03F 9/00, H01L 23/544

(54) **INFORMATION DETERMINING APPARATUS AND METHOD**

(71) Applicant: ASML Netherlands B.V., 5500 AH Veldhoven (NL)
(72) Inventor: GAO, An, 5500 AH Veldhoven (NL); LALBAHADOERSING, Sanjaysingh, 5500 AH Veldhoven (NL); NIKIPELOV, Andrey, 5500 AH Veldhoven (NL)
(74) Representative: Peters, John Antoine

(57) **Abstract**

The present disclosure describes an apparatus 160 for determining information relating to at least one target alignment mark 114 in a semiconductor device substrate 110. The target alignment mark 114 is initially at least partially obscured by a carbon layer 120 on the substrate 110. The apparatus 160 includes an energy delivery system 140 configured to emit a laser beam 132 for modifying at least one portion 134 of the carbon layer 120 to cause a phase change in the at least one portion 134 that increases the transparency of the portion 134. An optical signal 136 can propagate through the modified portion 134 to determine information relating to the target alignment mark 114.

## Description

### FIELD

The present disclosure relates to determining information during manufacture of a semiconductor device.

### BACKGROUND

A lithographic apparatus is a machine constructed to apply a desired pattern onto a substrate. A lithographic apparatus can be used, for example, in the manufacture of integrated circuits (ICs). A lithographic apparatus may, for example, project a pattern (also often referred to as "design layout" or "design") at a patterning device (e.g., a mask) onto a layer of radiation-sensitive material (resist) provided on a substrate (e.g., a wafer).

To project a pattern on a substrate a lithographic apparatus may use electromagnetic radiation. The wavelength of this radiation determines the minimum size of features which can be formed on the substrate. Typical wavelengths currently in use are 365 nm (i-line), 248 nm, 193 nm and 13.5 nm. A lithographic apparatus, which uses extreme ultraviolet (EUV) radiation, having a wavelength within the range 4-20 nm, for example 6.7 nm or 13.5 nm, may be used to form smaller features on a substrate than a lithographic apparatus which uses, for example, radiation with a wavelength of 193 nm.

Amorphous carbon layers, which may be used as so-called "hard masks", are deposited on certain substrate layers in order to provide a high etch selectivity as part of an IC or semiconductor device manufacturing process. Carbon layers may be used for etching deep, high aspect ratio structures within ICs. Amorphous carbon layers are widely used in Dynamic Random-Access Memory (DRAM) and 3D Negative-AND (NAND) devices, for example. However, carbon layers may also be used in other types of ICs and semiconductor devices.

At various stages during the IC manufacturing process, it may be necessary to align a substrate comprising an IC or semiconductor device such that a pattern of structures forming part of the IC or semiconductor device is accurately printed on top of underlying patterns. A misalignment may result in a so-called overlay (OV) error between adjacent layers in the IC or semiconductor device, which may result in a non-operational or sub-optimal device. In order to verify the alignment of the IC or semiconductor device, an appropriate instrument such as an alignment sensor may be used to measure information such as the position and/or orientation of a feature such as an alignment feature or other mark provided in at least one of the layers.

If a carbon layer is present, the alignment sensor may not be able to detect the features underlying the carbon layer due to the carbon layer absorbing radiation at the alignment sensor operating wavelength(s). Without accurate detection of these features, it may be difficult to achieve the necessary accuracy (e.g. nm placement accuracy in some cases) for printing structures in the layers of the substrate.

A current approach for alignment of a substrate comprising a carbon layer includes providing additional alignment features or marks in upper or intermediate layers of the substrate to determine the alignment of the substrate using an alignment sensor. In an example, the alignment sensor may be configured to detect a reflection from an alignment feature in a top surface of an amorphous carbon layer.

### SUMMARY

According to an example of the present disclosure there is provided an apparatus for determining information relating to at least one feature in a semiconductor device substrate. The at least one feature may be at least partially obscured by a layer comprising carbon, such that an optical signal for determining the information relating to the at least one feature may be prevented from reaching the feature. The apparatus may comprise an energy delivery system. The energy delivery system may be configured to emit radiation and/or particles for modifying at least one portion of the layer. Modifying the at least one portion of the layer may increase its transparency when or after the radiation and/or particles is incident thereon, such that at least part of the optical signal can propagate through the at least one portion of the layer for determining the information relating to the at least one feature.

In use, the energy delivery system may structurally modify the at least one portion of the layer comprising carbon, which may comprise or define a hard mask of the substrate, such that the transparency of the at least one portion may be increased. Increasing the transparency of the portion may allow the optical signal for determining the information relating to the at least one feature to propagate through the at least one portion to reach the feature, which may be in the form of an alignment mark, target alignment mark, overlay feature, metrology target, or any other feature in the substrate. The optical signal may interact with the at least one feature such that a return optical signal may propagate through the at least one portion. At least one property of the return optical signal may be measured in order to determine the information relating to the at least one feature. The information provided by the return optical signal may indicate at least one of: the presence, position, orientation, and/or the like of the at least one feature by allowing a direct measurement through the modified at least one portion by the optical signal. Allowing the direct measurement may mean that fewer litho and/or etching and/or deposition steps are required during manufacture of the semiconductor device substrate, which may reduce the time and expense involved in the manufacturing process. The direct measurement may allow the apparatus to more accurately determine the alignment of the substrate than an indirect alignment method, which may decrease the error in the overlay between the layers comprising semiconductor structures, conductor structures, insulator structures and/or other structures.

The energy delivery system may be configured to emit a beam for modifying the at least one portion of the layer by reducing the extinction coefficient of the carbon at the at least one portion of the layer.

The energy delivery system may be configured to emit a beam for modifying the at least one portion of the layer by causing a phase change in the carbon (e.g. at the at least one portion of the layer) and/or causing an increase in the concentration of sp3-coordinated carbon atoms (e.g. tetravalent carbon atoms) at the at least one portion of the layer.

The beam may comprise the radiation and/or particles.

Causing the phase change in the carbon may reduce the extinction coefficient of the layer for a given wavelength. For example, modifying the layer may cause a reduction in the extinction coefficient 'k' from above 0.4 to below 0.4, 0.2, 0.1, or the like.

The phase change may modify the carbon at the at least one portion of the layer such that the carbon forms at least one of: diamond; and diamond-like carbon.

The layer may comprise amorphous carbon, graphite, DLC and/or diamond, or any other form of carbon. The layer may comprise a material which is different to graphite or DLC. The layer may comprise at least 10-50%, or any other percentage, of carbon or doped carbon. The layer may comprise carbon doped with at least one of: boron, tungsten, nitrogen and/or any other appropriate element, compound or impurity.

The size of nano-diamond domains (e.g. grains in DLC, or the like) may be limited to about minimum in the pair of values (n^{-0.3}, h), where n is the concentration of dopants and h is the thickness of the layer. The micro-diamonds may behave as efficient scattering centres for the radiation of an alignment system for determining the information. Examples of wavelengths which may be scattered by the microdiamonds comprise: 0.5 to 1 µm, 1 to 2 µm, or any other possible wavelength ranges. Replacing the microdiamonds with smaller scatterers such as nano-diamonds (e.g. d<0.1 µm) may improve the visibility of the at least one feature through the at least one portion, which may be due to less scattering occurring in the layer. Appropriate selection of an alignment determination system or other optical system operating at a certain wavelength or wavelengths may reduce the effect of the scattering depending on the size and/or concentration of the scatterers in the layer. Appropriate selection of composition and/or thickness of the layer comprising carbon and/or sublayers within this layer in combination with adjusting the fluence and/or power and/or phase distribution of the radiation and/or particles of the energy delivery system may reduce the average (or maximum) size of the scatterers, for example, by converting the layer to comprise nano-diamonds instead of micro-diamonds, or the like.

Diamond and diamond-like carbon (DLC) may have an extinction coefficient of below 0.1 for at least one wavelength in the visible and/or the infrared spectrum.

The energy delivery system may comprise at least one of: at least one laser for emitting the radiation and/or at least one source of a focused beam of energetic particles.

The at least one laser may be configured to irradiate the at least one portion in a scanner, for example, a scanner used during the manufacturing process if resist has been applied to the substrate. It will be appreciated that distortion of resist may occur in the scanner, since resist has a lower boiling temperature than the layer comprising carbon. The at least one laser may be configured to irradiate the at least one portion using a separate energy source, for example, as part of a standalone tool for modifying the at least one portion and/or for determining information relating to the at least one feature. In this example, laser irradiation of the at least one portion may be performed prior to application of optional extra hard mask material, bottom anti-reflection coating (BARC), and/or resist layers on the substrate.

Replacing at least one litho-etch step during manufacture of the substrate, with a potentially much cheaper laser irradiation step, may improve overlay by direct alignment through the layer comprising the at least one portion. Time and expense may be saved by avoiding a step that includes refilling the clear out by material that is transparent for the wavelength of the optical signal and, optionally, etch resistant.

The at least one laser may comprise a pulsed laser source configured to emit a series of laser pulses. The pulse laser source may be configured to emit at least one laser pulse.

The at least one laser may be configured to emit radiation having at least one wavelength in a range from 4 nm to 3 µm. It will be appreciated that the radiation may comprise other wavelength(s) or several wavelengths, for example an output of a harmonic generator, or the like.

The at least one laser may be configured to emit one or more of: visible and/or infrared laser pulses with a pulse duration in a range from 5 fs to 500 ps; ultraviolet laser pulses with a pulse duration in the range 1 ps to 500 ns; and soft X-ray to DUV laser pulses with a pulse duration in the range 1 fs to 100 ns, or the like. It will be appreciated that the at least one laser may be configured to emit laser pulses of other pulse duration(s) such as microsecond, nanosecond, picosecond, femtosecond, attosecond pulses, or the like, and/or other wavelength(s) such as in the x-ray, soft x-ray, EUV, DUV, UV, visible, IR, mid-IR, far-IR, THz, or other parts of the electromagnetic spectrum.

The at least one laser may be configured to emit an initial pulse train comprising at least one laser pulse of a first pulse duration. The at least one laser may be further configured to emit a subsequent pulse train comprising at least one laser pulse of a shorter, second pulse duration.

The initial pulse train may comprise a pre-pulse, which may comprise nanosecond and/or picosecond laser pulses. The subsequent pulse train may comprise femtosecond laser pulses. The interaction of the pulse train(s) with the layer may result in a change in the temperature and/or pressure in the at least one portion. By using different pulse durations, the nature of the interaction between the laser pulses and the layer may be controlled such that the temperature and pressure in the at least one portion may be decoupled. For example, there may be a temperature rise associated with the initial pulse train, which may comprise at least one of: nanosecond, picosecond, and femtosecond pulses. There may be a pressure and/or temperature rise associated with the subsequent pulse train, which may comprise femtosecond pulses. By providing at least one laser with at least one different pulse duration, which may have a certain effect on the interaction between the laser pulse and the layer, it may be possible to provide fine or enhanced control of the properties in the at least one portion. For example, it may be possible to control the size, distribution and/or debris particle generation as well as the size of the grains of the phase-changed material by appropriate selection of laser parameters and/or the delay between two or more pulse trains. Nanosecond pulses may be used for initiating the process of modifying the layer. For example, by starting with nanosecond pulses, material in the at least one portion may thermalize at greater than 500°C, 1000°C, 2000°C, or the like. By using a femtosecond pulses, the pressure and/or temperature involved may be significantly larger than for nanosecond pulses. For example, the pressure pulses may be of order of 0.1-10 GigaPascals, or any other pressure; and the temperature involved may be of order 100-10,000°C, or any other temperature. It will be appreciated that any other temperature and/or pressure may be generated in the layer during modification by the radiation and/or particles.

It will be appreciated that any appropriate selection of laser pulses may be used for providing the modification of the at least one portion. For example, while the present example describes the subsequent pulse train as comprising femtosecond pulses, it may be possible to use nanosecond and/or picosecond pulses in the subsequent pulse train. Although nanosecond, picosecond and femtosecond pulse durations are described, it will be appreciated that other pulse duration regimes may be used, such as microsecond, attosecond, and/or the like for either or both of the initial and subsequent pulse trains. It will be further appreciated that controlling other parameters such as pulse energy, number of pulses, peak radiant fluence, laser repetition rate, dispersion, wavelength(s), polarization, and/or the like, may influence the modification of the at least one portion.

The at least one laser may be configured to emit radiation having a peak radiant fluence or intensity of radiation below an ablation threshold for the layer.

If at least one pulse has a peak radiant fluence or intensity that exceeds an ablation threshold, debris particles may be generated, which may pose a risk for subsequent imaging and overall yield. It will be appreciated that other parameters such as number of pulses, laser repetition rate, thermal conductivity, extinction and/or refraction coefficients of the layer, and/or the like may influence the ablation threshold.

The at least one laser may be configured to emit at least one of: a linear polarized radiation; non-linear polarized radiation; elliptical polarized radiation; and spiral polarized radiation.

The at least one laser may be configured to emit a sequence of laser pulses. Each laser pulse may have one of: linear polarization; circular polarization; elliptical polarization; and spiral polarization, and/or a sequence of laser pulses with some pulses within the train having a different polarization to other pulses within the train, or the like. The at least one laser may be configured to change the polarization of at least one pulse in the sequence of laser pulses. In an example, spiral polarization may be more effective than elliptical polarization, which itself may be more effective than linear polarization for generating smaller scatterers. It will be appreciated that any randomization of polarization may be beneficial.

Changing the polarization of the laser pulse may avoid a ripple formation in or adjacent to the at least one portion, which may emerge when near- and ablation-level femtosecond and/or picosecond pulses interact with materials with a relatively high concentration of electrons in the conducting band. Such ripples may have a periodicity that can deteriorate the characteristics of the return optical signal, which may decrease the quality of the information yielded by the at least one feature. The ripples may result in a periodic variation of optical density and/or thickness of the layer comprising carbon and/or modified carbon. The ripples may behave in a similar manner to a grating or other diffractive element, which may result in an arbitrary shift with respect to a diffractive pattern formed by the feature (which may be in the form of a grating). Such ripples may be the result of interaction of linearly polarized radiation with induced electron density waves (e.g. through polariton formation). The ripple formation process is described in Pan et al., "Threshold Dependence of Deep- and Near-subwaveleugth Ripples Formation on Natural MoS2 Induced by Femtosecoud Laser", Scientific Reports 6, 19571 (2016*),* which is incorporated herein by reference. The same mechanism (e.g. as described in Pan et al.) may lead to periodicity and/or larger size of the grains of the phase-changed material, thus any randomization of polarization, e.g. within at least one pulse (such as spiral polarization or the like) or between pulses (such as rotation of linear polarization from one pulse to another within a pulse train or changing to elliptical polarization, or the like) may be beneficial.

The energy delivery system may be configured to emit radiation and/or particles for pulsed heating of the at least one portion of the layer.

The particles may be configured to provide a fluence comparable with the fluence of the at least one laser. For example, the fluence may be in the range 0.01-1 J/cm² and/or the pulse duration may be less than 10 ns. It will be appreciated that the particles may be configured to provide a different fluence and/or pulse duration.

The energy delivery system may be configured to emit one or more of: an electron beam; an ion beam; a neutral beam; an extreme ultraviolet (EUV) beam in a range from 5 to 20 nm; and a beam comprising radiation having wavelengths in a range from 20 to 100 nm. The beam(s) may comprise radiation and/or particles.

Laser irradiation for modification of the at least one portion may be replaced by or accompanied by localized exposure of the at least one portion to continuous wave and/or pulsed ion beams or plasma with total fluence of greater than 0.01 J/cm² and/or a pulse duration of less than 10 ns. The ions implanted by the localized exposure may leave a hot track in which pulsed heat and quenching may take place such that diamond and/or DLC phases of carbon may be produced. The ion energy may be greater than 1 eV, and may be greater than100 eV. The ions used may comprise at least one of: C-ions and/or B, N, Ga and/or He, Ne, Ar, Kr, Xe, and/or the like. The use of one or more of these ions may promote outgassing and may leave the layer free of additional dopants. If ions or electrons are directed to the substrate as part of the energy delivery beam, the layer comprise carbon may be connected to a source of voltage/current or grounded so as to prevent charging effects that may defocus or deflect a focused charged particle beam incident on the layer. This deflecting effect may be possible if the original (e.g. high extinction coefficient) layer is conducting.

The apparatus may further comprise a feedback control system. The feedback control system may be configured to determine one or more parameters of the at least one portion of the layer. The feedback control system may be configured to control the energy delivery system based on the one or more parameters. The parameters may comprise at least one of: dimensions, transparency, optical coefficients (e.g. refraction or extinction), scattering and the like.

The feedback control system may comprise a radiation sensor. The radiation sensor may be configured to receive radiation from the at least one portion of the layer. The feedback control system may be configured to determine the one or more parameters of the at least one portion of the layer based on the received radiation.

The feedback control system may be configured to optimise the number and/or intensity of laser irradiating pulses and/or emission of particles by the energy delivery system. The feedback control system may be configured to stop and/or control the phase conversion when needed.

The feedback control system may comprise a control unit. The control unit may be configured to determine one or more of the parameters. The control unit may be operable to control any other part of the apparatus, for example, the energy delivery system, the radiation sensor, and the like. The feedback control system may be configured to regulate, control or otherwise vary the energy delivery system to control the modification of the at least one portion. The feedback control system may be operable to receive a signal, such as from a radiation sensor, indicating that the at least one portion has been sufficiently modified (e.g. made sufficiently transparent). The feedback control system may be operable to use the signal to determine whether to stop, or to continue, or vary the modification of the at least one portion.

The feedback control system may be configured to ensure that at least one layer below the layer comprising carbon may remain relatively unaffected by the modification of the at least one portion. For example, the energy delivery system may be controlled such that the generation of high pressure and/or temperature regions in the layer may be controlled following each of laser and/or particle pulses. Each subsequent pulse may propagate deeper into the layer comprising carbon. Each modified layer of the at least one portion may become more and more transparent with each pulse. The feedback control system may prevent at least one layer underlying the layer comprising carbon from being affected or substantially affected by the pulses.

The feedback control system may be configured such that at least one property of the return optical signal may be revealed by at least one of: reflected, scattered and/or diffracted optical signal from the at least one feature, which may be used to provide information regarding at least one layer of the substrate. Information such as polarization, wavelength(s), intensity, spectral intensity, an interference pattern, or the like, may be used to characterize at least one parameter such as thickness, optical length, refractive index 'n', extinction coefficient 'k', the composition, and/or the like of at least one layer in the substrate. At least one light source and/or the same radiation and/or particles as used for the modification may provide the optical signal and/or return optical signal. The amplitude and/or polarization of the light source and/or the radiation and/or particles provided by the energy delivery system may be attenuated and/or tuned for use in a metrology method, which may be used to determine the alignment of the substrate. The size of a metrology illumination spot of the optical signal for irradiating the at least one feature may substantially overlap with size of the modified portion in the layer, or may fit within the size of the modified portion.

The feedback control system may be configured such that at least one property of the optical signal for propagating through the substrate within the area of the modified at least one portion may be used to determine whether the at least one feature has been sufficiently illuminated, for example by back-illumination of the feature or in another illumination direction. The substrate may be illuminated, for example back-illuminated, with e.g. infrared or mid-infrared radiation (which may comprise wavelengths for which silicon is transparent) so that radiation may leak through the at least one portion once the DLC/diamond phase within the modified at least one portion is sufficiently thick and/or where the residual opacity of the layer comprising carbon may be sufficiently reduced. The feedback control system may be configured to monitor leakage of radiation (e.g. the infrared or mid-infrared radiation, or the like), and may be used to detect a moment to stop the modification of the at least one portion (for example, if the amount of radiation leaks exceeds a threshold level, or the like).

The feedback control system may be configured to monitor for plasma production or other forms of excitation of radiation by the energy delivery system. If plasma is produced or atoms/molecules are excited by at least one of the laser pulses and/or particles, optical spectroscopy or another technique may be used to sense the presence of the plasma or excitation, for example, if the diamond or DLC phase has modified the overall thickness of the layer comprising carbon.

The layer comprising carbon may attenuate or absorb radiation, for example from laser pulses, delivered by the energy delivery system, and/or may absorb particles delivered by the energy delivery system. The radiation and/or particles may initially modify an upper surface of the at least one portion of the layer. The upper surface may comprise an upper sub-layer of the layer. Modifying the upper sub-layer may cause the upper sub-layer to increase its transparency to the radiation and/or particles. The increased transparency of the upper sub-layer may provide a reduced attenuation/absorption to the radiation and/or particles such that if more radiation and/or particles are delivered (e.g. in the form a subsequent laser pulse or particle pulse), the radiation and/or particles may propagate through the modified upper sub-layer and modify a lower sub-layer beneath the upper sub-layer to cause an increase in transparency of at least one lower sub-layer(s). In an example, as each radiation and/or particle pulse modifies successive (e.g. lower) sub-layers within the layer, subsequent pulses may propagate deeper and deeper into the layer until the pulses may propagate all the way through the layer (e.g. through its overall thickness) to permit the pulses (and/or an optical signal) to access layer(s) of the substrate beneath the layer comprising carbon. Upon modification of the at least one portion of the layer, for example through the overall thickness of the layer, a pulse from the energy delivery system may propagate with little attenuation through the modified layer comprising carbon, which may cause at least one other chemical element or molecules (e.g. present in another layer and not present in the layer comprising carbon) of the substrate to be excited, which may cause the emission of a characteristic wavelength or spectrum, which may be an indication that the modification of the at least one portion is sufficient to permit the optical signal to propagate through the at least one portion. For example, it may be possible to distinguish between radiation emitted during modification of the layer comprising carbon and radiation (which may comprise at least one different wavelength to the radiation emitted during modification of the layer comprising carbon) emitted by the at least one other element of the substrate.

The feedback control system may be configured to characterise at least one property of radiation reflected, scattered, diffracted by the at least one portion. The feedback control system may comprise at least one of: a Raman detection system; a scanning electron microscope, or any other instrument for measuring a property of radiation reflected, scattered and/or diffractive by the feature. The Raman detection system may be configured to detect a Raman signal and/or a surface-enhanced Raman signal generated by the at least one portion, which may be used to characterise the at least one portion. The Raman detection system may be configured to provide information regarding the ratio of sp2/sp3 coordinated carbon atoms e.g. at the topmost layer of the modified at least one portion. A scanning electron microscope, or the like, may be used to characterise the at least one portion. By measuring the compression, indentation, or the like of the layer comprising carbon, it may possible to determine which part of the thickness of the layer comprising carbon has been phase converted.
The received radiation may comprise one or more of:
the radiation from the energy delivery system reflected or scattered from the at least one portion of the layer; radiation that has propagated through the at least one portion of the layer and that has been emitted from a radiation source configured to backlight the semiconductor device substrate; radiation excited in the portion of the layer by radiation and/or particles from the energy delivery system; and radiation from an auxiliary light source, directed to and reflected and/or scattered from a spot that overlaps substantially with the portion of the layer that is modified by the energy delivery system. The radiation source may define a further radiation source configured to backlight the semiconductor device substrate. The radiation source may be configured to emit radiation and/or particles, which may be substantially transmissible through the substrate, but which may be substantially absorbed by the unmodified layer. The radiation source may comprise the auxiliary light source. The auxiliary light source may comprise a backlight for backlighting the semiconductor substrate.

The energy delivery system may be configured to emit radiation and/or particles for modifying the transparency of the at least one portion of the layer to a depth less than the overall thickness of the layer.

The apparatus may comprise a layer deposition system for depositing the layer on the substrate.

The layer deposition system may be configured to deposit a first sub-layer of the layer on the substrate. The energy delivery system may be operable to modify at least one portion in the first sub-layer.

The layer deposition system may be configured to deposit a second sub-layer of the layer on the first sub-layer after modification of the at least one portion of the first sub-layer.

The layer deposition system may be operable to vary deposition conditions for the creation of at least one seed sub-layer in the layer. The seed sub-layer may comprise sp3-coordinated carbon for acting as seed sub-layer for nanodiamond nucleation and/or diamond-like carbon, DLC, or the like. The concentration of sp3 coordinated carbon atoms in the seed sub-layer may be higher than in the other sub-layers.

The seed sub-layer may be thinner, for example more than 2x, more than 10x, or any other factor, thinner than the overall layer thickness.

The layer deposition system may be configured to deposit the at least one seed sub-layer at an upper surface of the layer. The layer deposition chamber or production method may be configured to convert the topmost part of the layer comprising carbon to a seed sub-layer, for example, by exposing the layer to energetic ions of, for example, noble gas.

The layer deposition system may be configured to subject a substrate to a sequence of procedures. The layer deposition system may be configured to deposit a layer comprising carbon on the substrate, which may comprise 50 to 100 % of the overall thickness of the layer. It will be appreciated that a different thickness may be deposited before modification of the layer. The apparatus may be configured to modify the at least one portion of the layer above some or all of the features in the substrate to reduce the extinction coefficient of the at least one portion. The apparatus may be configured such that an area of the at least one portion is 0.1-10 times the area of the corresponding feature, and may substantially overlap with the corresponding feature. The apparatus may be configured to modify only part of the thickness of the layer so the thickness of the layer with reduced extinction coefficient may be less than or equal to the thickness of the initial layer.

The layer deposition system and/or a manufacturing procedure may be configured to perform a chemical-mechanical polishing (CMP) step (e.g. using a chemical-mechanical polisher, or the like) for at least one of: planarizing; and removing debris particles, which may result from ablation plumes or the like, from a surface of the substrate. The layer deposition system may be configured to apply a removable layer (e.g. via spin coating, or the like) prior to the modification of the at least one portion. The removable layer may be removed (e.g. by washing or the like) to remove deposited debris particles e.g. once at least one feature in the substrate becomes visible after the modification of the at least one portion.

The CMP may be used to reduce or eliminate any ripples formed in the surface of the substrate and/or at the edge of the at least one modified portion. Alternatively or additionally, the CMP may be used to remove debris particles.

The layer deposition system may be configured to deposit a remainder of the overall thickness of the layer e.g. after modification of the at least one portion. For example, 0 to 50%, or any other percentage range, of the overall layer thickness may be deposited, depending on the initial thickness deposited.

The layer deposition system may be configured to deposit at least one of: a bottom anti-reflection coating (BARC); resist; and any other layer on the substrate. The layer deposition system may be configured such that the BARC and/or resist deposition may be relatively uniform or planar. There may be a difference in the wetting of DLC/diamond and amorphous carbon by BARC and/or resist. Depositing a layer of amorphous carbon or the like, e.g. a relatively thin layer that may permit penetration of the relatively thin layer by the optical signal, may reduce the difference in the wetting properties of BARC and/or resist, or the like.

The layer deposition system may be configured to deposit the layer comprising carbon such that an unmodified portion of the layer may be above or below at least one modified portion of the layer, which may provide a layer having at least one modified portion nearer to the upper surface of the layer, or nearer to the lower surface of the layer (e.g. which may be in contact with an underlying layer of the substrate). Providing an unmodified layer below the modified portion may ensure that a user-specified ashing recipe for the layer may be used.

The apparatus may comprise a debris removal system for removing from a surface of the layer debris particles generated during the modification.

Modifying the layer in a vacuum or at low pressure may reduce or eliminate debris particle deposition on a surface of the substrate. Examples of pressure conditions for reducing or eliminating debris particle deposition are described in Harilal et al. "Background gas collisioual effects on expanding fs and ns laser ablation plumes", Appl. Phys. A, Vol. 117(1), pp. 319-326 (2014*),* which is incorporated herein by reference.

The debris removal system may comprise a radiation source for emitting radiation for irradiating the debris particles formed in an ablation plume during modification of the least one portion of the layer for reducing the debris particle size and/or a number of debris particles in the ablation plume.

The debris removal system may be configured to irradiate the ablation plume with at least one laser pulse, for example in the form of an after-pulse, or the like. The laser pulse may have a lower energy and/or peak fluence than the radiation and/or particles for modifying the at least one portion. The laser pulse may have a duration of less than 10 ns, less than 0.1 ns, or any other appropriate pulse duration. The laser pulse may be configured to follow each or some of the pulses for modifying the at least one portion, for example, with a delay of less than 10 µs, less than 1 µs, or any other appropriate delay. The after-pulse may effectively be absorbed by particles in the ablation plasma plume, which may evaporate the particles or at least reduce their size to less than or much less than 100 nm such that the particles do not get imaged or deteriorate yield even if left on the substrate.

The debris removal system may comprise an electric discharger for generating a plasma above the at least one portion of the layer during modification thereof. The plasma may be configured to capture charged particles (e.g. which may be produced and/or charged in the ablation plume and may prevent their re-deposition). Alternatively or in addition, the apparatus may be configured to apply a bias to the substrate comprising the layer, such that an electric field may repel charged particles produced in the ablation plume from the substrate and/or may prevent re-deposition of the charged particles.

Maintaining an electric discharge above the layer during modification may be performed such that moderate temperature ions may be generated. For example, Titanium ions may be generated with an energy of less than 100eV, and optionally less than 10eV. Particles generated within an ablation plasma plume may be generally negatively charged, which may result in the negative particles being retained in the positive potential of the plasma.

The debris removal system may be configured to incline the semiconductor device substrate, such that the debris particles may move away from the layer under force of gravity, or by any other external force or pressure. The substrate may be inclined during modification of the at least one portion such that gravity may move the debris particles away from the layer.

The debris removal system may be configured to apply a removable layer to a surface of the layer, wherein the debris particles may be collected on the removable layer. The debris removal system may be further configured to remove the removable layer after modification of the at least one portion of the layer.

The debris removal system may be configured to remove the removable layer at the location of the at least one portion of the layer before the energy delivery system emits the radiation and/or particles.

The debris removal system may be configured to provide a reactive medium in proximity to the at least one portion of the layer, for example, such that only the products of reaction of material within the ablation plume may be substantially volatile or soluble. The reactive medium may be gas or liquid. The reactive medium may be transparent to the radiation and/or particles. The activation energy may be provided by the high temperature within the plume and/or by direct photo-excitation by the radiation and/or particles. The reactive medium may be configured to convert vapour or particles in the plasma plume to the volatile or soluble form, which may be subsequently removed by diffusion and/or flow.

The modification of the at least one portion may be performed in the reactive medium. The reactive medium may comprise at least one of: oxygen, hydrogen, halogens, air, water vapour, liquid water, CO₂ (e.g. gas or liquid) or the like. The reactive medium may be configured to turn into volatile or soluble oxides, halides and the like e.g. so as to eliminate the debris particles which may be generated in an ablation plume. Debris particles may react within the ablation plume with reactive medium, which may be in the form of a gas or liquid, and form volatiles or soluble particles/molecules that can be removed by flow and/or diffusion. The debris particles may be condensed from the high density vapour or be produced in the liquid form, and/or may comprise carbon, tungsten, boron, nitrogen and/or any other elements.

The apparatus may further comprise a chamber configured to hold a liquid. The semiconductor device substrate may be at least partially immersed in the liquid at least during emission of the radiation and/or particles by the energy delivery system.

The modification of the at least one portion may be performed in liquid (e.g. water, alcohol, liquid carbon dioxide, perfluorinated fluids, heat transfer fluids, or the like). The substrate may be at least partially immersed in a bath and/or have a liquid film applied (e.g. which may comprise a condensation, or the like) on the surface thereof.

Performing the modification in liquid may allow the thermal stress upon wafer to be reduced. The liquid may act to provide a heat sink by conduction and/or evaporation and/or dissociation. The liquid may act to improve quenching (e.g. so carbon may be heated up to circa. 4000 to 5000 °C, or any other potential or appropriate temperature), and then may be quickly cooled to preserve the diamond or DLC phase.

Performing the modification of the at least one portion of the substrate immersed in the liquid may suppress or prevent removal of carbon (e.g. and other elements) by a Coulomb explosion and/or evaporation process, which may be useful for maintaining the layer resistance to a subsequent etching step or maintaining the layer thickness (e.g. by minimizing the difference between modified and unmodified portions within the layer), which may eliminate the need to perform a planarization step and/or may reduce the difference in wetting/distribution for the steps of application of BARC and/or resist.

The apparatus may comprise a liquid film applicator configured to apply a liquid film to a surface of the layer before the energy delivery system emits the radiation and/or particles.

The apparatus may comprise an optical system configured to transmit an optical signal through the at least one portion of the layer for determining information relating to the at least one feature.

The optical system may comprise any appropriate instrument for determining information relating to the at least one feature. The optical system may be configured to receive an optical signal reflected, scattered and/or diffracted from the at least one feature such that information relating to the at least one feature can be determined. The optical system may be configured to provide the optical signal for propagating the modified at least one portion.

The apparatus may comprise a substrate alignment system for determining information relating to the at least one feature based on a return optical signal received through the at least one portion of the layer.

The at least one feature may be irradiated by the optical signal, which may initially propagate through the at least one portion. The optical signal may interact (e.g. reflect, scatter and/or diffract) with the at least one feature to form a return optical signal, which may subsequently propagate through the at least one portion. The at least one feature may be irradiated by the optical signal, which may not initially propagate through the at least one portion. For example, the at least one feature may be irradiated by the optical signal arriving from at least one different direction such that the optical signal may not initially pass through the at least one portion. The return optical signal may subsequently propagate through the at least one portion.

The substrate alignment system may be configured to determine at least one of: the presence; position and orientation, or the like, of the at least one feature in order to determine whether the substrate is aligned.

The substrate alignment system may be configured to control the relative positioning between the substrate and a lithography apparatus or lithographic tool to align the substrate therein.

The optical system and/or the substrate alignment system may comprise any appropriate instrument for at least one of: measuring; and analysing information obtained from the at least one feature. Examples of techniques for determining information relating to the at least one feature may comprise at least one of: using a Smart Alignment Sensor Hybrid (SMASH) system such as produced by the applicant of the present disclosure and/or a phase-grating alignment technique such as produced by the applicant of the present disclosure and/or an interferometric technique that uses a return optical signal from the at least one feature to determine the information. The SMASH system may not require a full area of the at least one feature to be visible (e.g. if the area of the modified portion is less than the area of the corresponding feature) and/or well illuminated by the optical signal to determine the information. The SMASH system may be operable in the visible and/or infrared spectral ranges. The wavelength(s) used by the SMASH system or any other instrument may at least partially penetrate the layer comprising carbon, for example, if part of the layer is obscuring the at least one feature. Selection of appropriate wavelengths may permit the optical signal provided by the SMASH system or any other appropriate instrument to penetrate the layer, even if the layer has not been completely modified through its overall thickness, or if the modification is incomplete such that the modified layer thickness is less than its overall thickness, and/or if any other layers have been deposited on the substrate.

The feature may comprise an alignment or overlay mark, or the like.

The modified layer may comprise at least 20% carbon, or optionally may comprise at least 50% carbon.

According to an example of the present disclosure there is provided a lithography apparatus comprising the apparatus of any example of the present disclosure.

According to an example of the present disclosure there is provided a lithographic tool comprising the apparatus of any example of the present disclosure.

According to an example of the present disclosure there is provided a method for determining information relating to at least one feature in a semiconductor device substrate. The at least one feature may be at least partially obscured by a layer comprising carbon, such that an optical signal for determining information relating to the at least one feature may be prevented from reaching the feature. The method may comprise: emitting, by an energy delivery system, radiation and/or particles for modifying at least one portion of the layer to increase its transparency when or after the radiation and/or particles is incident thereon. Modifying the at least one portion may be such that at least part of the optical signal for determining the information relating to the at least one feature can propagate through the at least one portion of the layer for determining the information relating to the at least one feature.

The method may comprise using the energy delivery system to emit a beam to modify the at least one portion of the layer by reducing the extinction coefficient of the at least one portion of the layer e.g. by changing the valence state of some of the carbon atoms within the layer (e.g. increasing the content of sp3-coordinated carbon atoms and/or reducing the content of sp2 coordinated carbon atoms).

The beam may comprise the radiation and/or particles.

The method may comprise using the energy delivery system to emit a beam to modify the at least one portion of the layer by causing a phase change in the carbon (e.g. at the at least one portion of the layer) and/or causing an increase in the concentration of sp3-coordinated carbon atoms (e.g. tetravalent carbon atoms) at the at least one portion of the layer.

The method may comprise modifying the carbon at the at least one portion of the layer such that the carbon forms at least one of: diamond; and diamond-like carbon.

The method may comprise using at least one laser to emit the radiation and/or particles. The method may comprise using at least one laser for emitting the radiation and/or at least one source of a focused beam of energetic particles.

The method may comprise using a pulsed laser source to emit a series of laser pulses.

The method may comprise emitting radiation having at least one wavelength in a range from 4 nm to 3 µm.

The method may comprise using the at least one laser to emit one or more of: visible and/or infrared laser pulses with a pulse duration in a range from 5 fs to 500 ps; ultraviolet laser pulses with a pulse duration in the range 1 ps to 500 ns; soft X-ray to DUV laser pulses with a pulse duration in the range 1 fs to 100 ns, or the like.

The method may comprise using the at least one laser to emit an initial pulse train comprising at least one laser pulse of a first pulse duration. The method may further comprise emitting a subsequent pulse train comprising at least one laser pulse of a shorter, second pulse duration.

The method may comprise using the at least one laser to emit radiation having a peak radiant fluence or intensity of radiation below an ablation threshold for the layer.

The method may comprise using the at least one laser to emit radiation and/or particles having at least one of: a linear polarized radiation; non-linear polarized radiation; elliptical polarized radiation; and spiral polarized radiation.

The method may comprise using the at least one laser to emit a sequence of laser pulses, each laser pulse having one of: linear polarization; circular polarization; elliptical polarization; spiral polarization and/or a sequence of laser pulses with some pulses within the train having a different polarization to other pulses within the train.

The method may comprise emitting, by the energy delivery system, radiation and/or particles for pulsed heating of the at least one portion of the layer.

The method may comprise using the energy delivery system to emit one or more of: an electron beam; an ion beam; a neutral beam; an extreme ultraviolet (EUV) beam in a range from 5 to 20 nm; and a beam comprising radiation having wavelengths in a range from 20 to 100 nm. The beam(s) may comprise radiation and/or particles.

The method may comprise providing a current or bias voltage source, or grounding the layer comprising carbon to avoid charge build up provided by a charged particle beam.

The method may comprise using a feedback control system configured to determine one or more parameters of the at least one portion of the layer and to control the energy delivery system based on the one or more parameters.

The method may comprise using a radiation sensor of the feedback control system to receive radiation from the at least one portion of the layer. The method may comprise using the feedback control system to determine the one or more parameters of the at least one portion of the layer based on the received radiation.
The received radiation may comprise one or more of:
the radiation from the energy delivery system reflected or scattered from the at least one portion of the layer; radiation that has propagated through the at least one portion of the layer and that has been emitted from a radiation source configured to backlight the semiconductor device substrate; radiation excited in the portion of the layer by radiation and/or particles from the energy delivery system; and radiation from an auxiliary light source, directed to and reflected and/or scattered from a spot that overlaps substantially with the portion of the layer that is modified by the energy delivery system.

The method may comprise using the energy delivery system to emit radiation and/or particles to modify the transparency of the at least one portion of the layer to a depth less than the overall thickness of the layer.

The method may comprise using a layer deposition system to deposit the layer on the substrate.

The method may comprise using the layer deposition system to deposit a first sub-layer of the layer on the substrate. The method may comprise using the energy delivery system to modify at least one portion in the first sub-layer.

The method may comprise using the layer deposition system to deposit a second sub-layer of the layer on the first sub-layer after modification of the at least one portion of the first sub-layer. Any number of sub-layers may be deposited using the layer deposition system. Each sub-layer may have any appropriate composition e.g. dopants, impurities, other forms of carbon, or the like.

The method may comprise using the layer deposition system to vary deposition conditions to create at least one seed sub-layer in the layer. The seed sub-layer may comprise (e.g. an increased amount of) sp3-coordinated carbon for acting as seed sub-layer for nanodiamond nucleation and/or diamond-like carbon, DLC, or the like.

The method may comprise using the layer deposition system to deposit the at least one seed sub-layer at an upper surface of the layer. The method may comprise a means to convert a portion of the topmost layer to the seed sub-layer.

The method may comprise using a debris removal system to remove from a surface of the layer debris particles generated during the modification.

Using the debris removal system may comprise using a radiation source to emit radiation for irradiating the debris particles formed in an ablation plume during modification of the least one portion of the layer to reduce the debris particle size and/or a number of debris particles in the ablation plume.

The method may comprise using an electric discharge , for example generated by an electric discharger, to generate a plasma above the at least one portion of the layer during modification thereof. The plasma may be configured to capture particles (e.g. which may be produced and/or charged in the ablation plume and may prevent their re-deposition). Alternatively or in addition, the method may comprise applying a bias to the substrate comprising the layer, such that an electric field may repel charged particles produced in the ablation plume from the substrate and/or may prevent re-deposition of the charged particles.

The method may comprise using the debris removal system to incline the semiconductor device substrate, such that the debris particles may move away from the layer under force of gravity.

The method may comprise using the debris removal system to apply a removable layer to a surface of the layer. The debris particles may be collected on the removable layer. The method may comprise using the debris removal system to remove the removable layer after modification of the at least one portion of the layer.

The method may comprise using the debris removal system to remove the removable layer at the location of the at least one portion of the layer before the energy delivery system emits the radiation and/or particles.

The method may comprise using the debris removal system to provide a reactive medium in proximity to the at least one portion of the layer, for example, such that only the products of reaction of material within the ablation plume may be substantially volatile or soluble. The reactive medium may be gas or liquid. The reactive medium may be transparent to the radiation and/or particles. The activation energy may be provided by the high temperature within the plume and/or by direct photo-excitation by the radiation and/or particles. The reactive medium may convert vapour or particles in the plasma plume to the volatile or soluble form, which may be subsequently removed by diffusion and/or flow.

The method may comprise providing a chamber configured to hold a liquid, at least partially immersing the semiconductor device substrate in the liquid at least during emission of the radiation and/or particles by the energy delivery system.

The method may comprise using a liquid film applicator to apply a liquid film to a surface of the layer before the energy delivery system emits the radiation and/or particles.

The method may comprise using an optical system to transmit an optical signal through the at least one portion of the layer to determine information relating to the at least one feature.

The method may comprise using a substrate alignment system to determine information relating to the at least one feature based on a return optical signal received through the at least one portion of the layer.

The method may comprise using the substrate alignment system to determine at least one of: the presence; position and orientation of the at least one feature in order to determine whether the substrate is aligned.

The method may comprise using the substrate alignment system to control the relative positioning between the substrate and a lithography apparatus or lithographic tool to align the substrate therein.

According to an example of the present disclosure there is provided a computer program. The computer program may comprise instructions which, when executed on at least one processor, may cause the at least one processor to control an apparatus to carry out the method according to any example of the present disclosure.

According to an example of the present disclosure there is provided a carrier. The carrier may contain the computer program of any example of the present disclosure. The carrier may be one of an electronic signal, optical signal, radio signal, non-transitory computer readable storage medium, or the like.

At least one feature of any example, aspect or embodiment of the present disclosure may replace any corresponding feature of any example, aspect or embodiment of the present disclosure. At least one feature of any example, aspect or embodiment of the present disclosure may be combined with any other example, aspect or embodiment of the present disclosure.

### BRIEF DESCRIPTION OF THE DRAWINGS

Embodiments of the present disclosure will now be described, by way of example only, with reference to the accompanying schematic drawings, in which:
- Figure 1 depicts a schematic overview of a lithographic apparatus;
- Figure 2 depicts a schematic overview of a lithographic cell;
- Figure 3 depicts a schematic view of part of a substrate including alignment marks for assisting with the alignment of layers in the substrate;
- Figures 4a-4c depict schematic views of part of a substrate during different steps of a procedure for determining information relating to at least one feature in the substrate according to an example of the present disclosure;
- Figure 5 depicts a schematic overview of an energy delivery system according to an example of the present disclosure;
- Figure 6 depicts a schematic overview of a substrate alignment system according to an example of the present disclosure;
- Figure 7 depicts a schematic overview of an apparatus for determining information relating to at least one feature in a substrate according to an example of the present disclosure;
- Figure 8 depicts a schematic overview of a debris removal system for removing debris particles from a surface according to an example of the present disclosure;
- Figure 9 depicts a schematic overview of a layer deposition system for depositing at least one layer on a substrate according to an example of the present disclosure;
- Figure 10 depicts a schematic overview of parts of a method for determining information relating to at least one feature in a substrate according to an example of the present disclosure; and
- Figure 11 depicts a schematic overview of a feedback control system.

### DETAILED DESCRIPTION OF THE DRAWINGS

In the present document, the terms "radiation" and "beam" are used to encompass all types of electromagnetic radiation, including ultraviolet radiation (e.g. with a wavelength of 365, 248, 193, 157 or 126 nm) and EUV (extreme ultra-violet radiation, e.g. having a wavelength in the range of about 5-100 nm).

The term "reticle", "mask" or "patterning device" as employed in this text, unless stated otherwise, may be broadly interpreted as referring to a generic patterning device that can be used to endow an incoming radiation beam with a patterned cross-section, corresponding to a pattern that is to be created in a target portion of the substrate; the term "light valve" can also be used in this context. Besides the classic mask (transmissive or reflective; binary, phase-shifting, hybrid, etc.), examples of other such patterning devices include:
- a programmable mirror array. More information on such mirror arrays is given in U.S. Patent Nos. 5,296,891 and 5,523,193, which are incorporated herein by reference.
- a programmable LCD array. An example of such a construction is given in U. S. Patent No. 5,229,872, which is incorporated herein by reference.

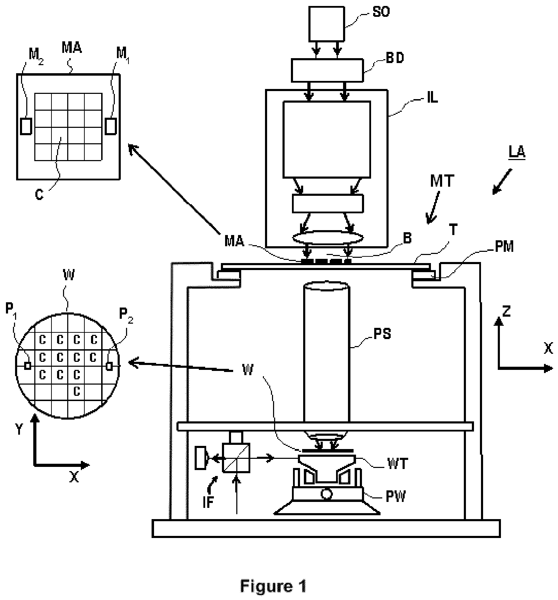

Figure 1 schematically depicts a lithographic apparatus LA. The lithographic apparatus LA includes an illumination system (also referred to as illuminator) IL configured to condition a radiation beam B (e.g., UV radiation, DUV radiation or EUV radiation), a support structure (e.g., a mask table) MT constructed to support a patterning device (e.g., a mask) MA and connected to a first positioner PM configured to accurately position the patterning device MA in accordance with certain parameters, a substrate table (e.g., a wafer table) WT constructed to hold a substrate (e.g., a resist coated wafer) W and connected to a second positioner PW configured to accurately position the substrate in accordance with certain parameters, and a projection system (e.g., a refractive projection lens system) PS configured to project a pattern imparted to the radiation beam B by patterning device MA onto a target portion C (e.g., comprising one or more dies) of the substrate W.

In operation, the illuminator IL receives a radiation beam from a radiation source SO, e.g. via a beam delivery system BD. The illumination system IL may include various types of optical components, such as refractive, reflective, magnetic, electromagnetic, electrostatic, or other types of optical components, or any combination thereof, for directing, shaping, or controlling radiation. The illuminator IL may be used to condition the radiation beam B to have a desired spatial and angular intensity distribution in its cross section at a plane of the patterning device MA.

The term "projection system" PS used herein should be broadly interpreted as encompassing various types of projection system, including refractive, reflective, catadioptric, anamorphic, magnetic, electromagnetic and electrostatic optical systems, or any combination thereof, as appropriate for the exposure radiation being used, or for other factors such as the use of an immersion liquid or the use of a vacuum. Any use of the term "projection lens" herein may be considered as synonymous with the more general term "projection system" PS.

The lithographic apparatus may be of a type wherein at least a portion of the substrate may be covered by a liquid having a relatively high refractive index, e.g., water, so as to fill a space between the projection system and the substrate - which is also referred to as immersion lithography. More information on immersion techniques is given in U. S. Patent No. 6,952,253 and in PCT publication No. WO99-49504, which are incorporated herein by reference.

The lithographic apparatus LA may also be of a type having two (dual stage) or more substrate tables WT and, for example, two or more support structure MT (not shown). In such "multiple stage" machines the additional tables / structures may be used in parallel, or preparatory steps may be carried out on one or more tables while one or more other tables are being used for exposing the design layout of the patterning device MA onto the substrate W.

In operation, the radiation beam B is incident on the patterning device (e.g., mask MA), which is held on the support structure (e.g., mask table MT), and is patterned by the patterning device MA. Having traversed the mask MA, the radiation beam B passes through the projection system PS, which focuses the beam onto a target portion C of the substrate W. With the aid of the second positioner PW and position sensor IF (e.g., an interferometric device, linear encoder, 2-D encoder or capacitive sensor), the substrate table WT can be moved accurately, e.g., so as to position different target portions C in the path of the radiation beam B. Similarly, the first positioner PM and possibly another position sensor (which is not explicitly depicted in Figure 1) may be used to accurately position the mask MA with respect to the path of the radiation beam B. Mask MA and substrate W may be aligned using mask alignment marks M1, M2 and substrate alignment marks P1, P2. Although the substrate alignment marks as illustrated occupy dedicated target portions, they may be located in spaces between target portions (these are known as scribe-lane alignment marks).

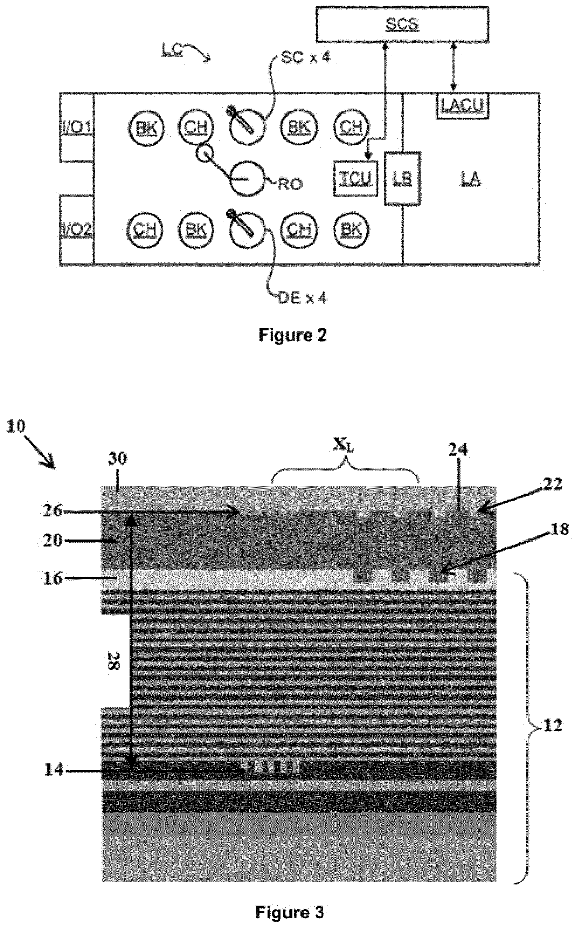

As shown in Figure 2 the lithographic apparatus LA may form part of a lithographic cell LC, also sometimes referred to as a lithocell or (litho)cluster, which often also includes apparatus to perform pre- and post-exposure processes on a substrate W. Conventionally these include spin coaters SC to deposit resist layers, developers DE to develop exposed resist, chill plates CH and bake plates BK, e.g. for conditioning the temperature of substrates W e.g. for conditioning solvents in the resist layers. A substrate handler, or robot, RO picks up substrates W from input/output ports I/O1, I/O2, moves them between the different process apparatus and delivers the substrates W to the loading bay LB of the lithographic apparatus LA. The devices in the lithocell, which are often also collectively referred to as the track, are typically under the control of a track control unit TCU that in itself may be controlled by a supervisory control system SCS, which may also control the lithographic apparatus LA, e.g. via lithography control unit LACU.

In order for the substrates W exposed by the lithographic apparatus LA to be exposed correctly and consistently, it is desirable to inspect substrates to measure properties of patterned structures, such as overlay errors between subsequent layers, line thicknesses, critical dimensions (CD), etc. For this purpose, inspection tools (not shown) may be included in the lithocell LC. If errors are detected, adjustments, for example, may be made to exposures of subsequent substrates or to other processing steps that are to be performed on the substrates W, especially if the inspection is done before other substrates W of the same batch or lot are still to be exposed or processed.

An inspection apparatus, which may also be referred to as a metrology apparatus, is used to determine properties of the substrates W, and in particular, how properties of different substrates W vary or how properties associated with different layers of the same substrate W vary from layer to layer. The inspection apparatus may alternatively be constructed to identify defects on the substrate W and may, for example, be part of the lithocell LC, or may be integrated into the lithographic apparatus LA, or may even be a stand-alone device. The inspection apparatus may measure the properties on a latent image (image in a resist layer after the exposure), or on a semi-latent image (image in a resist layer after a post-exposure bake step PEB), or on a developed resist image (in which the exposed or unexposed parts of the resist have been removed), or even on an etched image (after a pattern transfer step such as etching).

The lithographic apparatus LA is configured to accurately reproduce the pattern onto the substrate. The positions and dimensions of the applied features need to be within certain tolerances. Position errors may occur due to an overlay error (often referred to as "overlay"). The overlay is the error in placing a first feature during a first exposure relative to a second feature during a second exposure. The lithographic apparatus minimizes the overlay errors by aligning each wafer accurately to a reference prior to patterning. This is done by measuring positions of alignment marks on the substrate using an alignment sensor. More information on the alignment procedure can be found in U.S. Patent Application Publication No. US20100214550, which is incorporated herein by reference. Pattern dimensioning (CD) errors may e.g. occur when the substrate is not positioned correctly with respect to a focal plane of the lithographic apparatus. These focal position errors may be associated with un-flatness of a substrate surface. The lithographic apparatus minimizes these focal position errors by measuring the substrate surface topography prior to patterning using a level sensor. Substrate height corrections are applied during subsequent patterning to assure correct imaging (focusing) of the patterning device onto the substrate. More information on the level sensor system can be found in U.S. Patent Application Publication No. US20070085991, which is incorporated herein by reference.

Besides the lithographic apparatus LA and the metrology apparatus MT other processing apparatus may be used during IC production as well. An etching station (not shown) processes the substrates after exposure of the pattern into the resist. The etch station transfers the pattern from the resist into one or more layers underlying the resist layer. Typically etching is based on application of a plasma medium. Local etching characteristics may e.g. be controlled using temperature control of the substrate or directing the plasma medium using a voltage controlled ring. More information on etching control can be found in international Patent Application Publication No. WO2011081645 and U.S. Patent Application Publication No. US 20060016561 which are incorporated herein by reference.

During the manufacturing of the ICs the process conditions for processing substrates using processing apparatus such as the lithographic apparatus or etching station may remain stable such that properties of the features remain within certain control limits. Stability of the process may be relevant for features of the functional parts of the IC, the product features. To ensure stable processing, process control capabilities need to be in place. Process control involves monitoring of processing data and implementation of means for process correction, e.g. control the processing apparatus based on characteristics of the processing data. Process control may be based on periodic measurement by the metrology apparatus MT, often referred to as "Advanced Process Control" (further also referenced to as APC). More information on APC can be found in U.S. Patent Application Publication No. US20120008127, which is incorporated herein by reference. A typical APC implementation involves periodic measurements on metrology features on the substrates to monitor and correct drifts associated with one or more processing apparatus. The metrology features reflect the response to process variations of the product features. The sensitivity of the metrology features to process variations may be different compared to the product features. In that case a so-called "Metrology To Device" offset (further also referenced to as MTD) may be determined. To mimic the behavior of product features the metrology targets may incorporate segmented features, assist features or features with a particular geometry and/or dimension. A carefully designed metrology target should respond in a similar fashion to process variations as the product features. More information on metrology target design can be found in international Patent Application Publication No. WO 2015101458 which is incorporated herein by reference.

The distribution of the locations across the substrate and/or patterning device where the metrology targets are present and/or measured is often referred to as the "sampling scheme". Typically the sampling scheme is selected based on an expected fingerprint of the relevant process parameter(s); areas on the substrate where a process parameter is expected to fluctuate are typically sampled more densely than areas where the process parameter is expected to be constant. Further there is a limit to the number of metrology measurements which may be performed based on the allowable impact of the metrology measurements on the throughput of the lithographic process. A carefully selected sampling scheme is important to accurately control the lithographic process without affecting throughput and/or assigning a too large area on the reticle or substrate to metrology features. Technology related to optimal positioning and/or measuring metrology targets is often referred to as "scheme optimization". More information on scheme optimization can be found in international Patent Application Publication No. WO 2015110191 and the European patent application, application number EP16193903.8 which are incorporated herein by reference.

Figure 3 depicts part of a substrate 10 including a number of intermediate layers 12 including a feature, which in this example is in the form of a target alignment mark 14 such as a grating, or the like. The target alignment mark 14 is etched into one of the intermediate layers 12. A number of additional intermediate layers 12 are deposited over the layer 12 including the target alignment mark 14. A further intermediate layer 12, which in this example is in the form of a nitride layer 16, is deposited on the additional intermediate layers 12. A first alignment mark 18 is etched into the nitride layer 16 at a defined lateral distance 'X_{L}' from the equivalent position of the target alignment mark 14.

A layer comprising carbon (hereinafter referred to as a "carbon layer" 20), which in this example is in the form of a carbon hard mask, is deposited on the nitride layer 16. Due to the shape of the etched first alignment mark 18 in the nitride layer 16, the deposition of the carbon layer 20 forms a corresponding second alignment mark 22 vertically above the first alignment mark 18 (e.g. on an upper surface 24 of the carbon layer 20). The second alignment mark 22 is substantially laterally aligned with the first alignment mark 18 underlying the carbon layer 20. By using the defined lateral distance 'X_{L}' it is possible to determine the lateral position of the target alignment mark 14 underlying the carbon layer 20 and the intermediate layers 12 and etch a further target alignment mark 26 in the upper surface 24 of the carbon layer 20. Since the target alignment mark 14 and the further target alignment mark 26 are approximately laterally aligned, it is possible to indirectly align the layers in the substrate 10 and ensure that any overlay (OV) 28 misalignment is minimized. A resist layer 30 can be deposited on the carbon layer 20 when required during the manufacturing process. As the OV 28 budget becomes tighter e.g. for ICs having smaller structures, this indirect alignment process may not provide sufficient accuracy to ensure that structures in the layers are appropriately laterally aligned relative to each other.

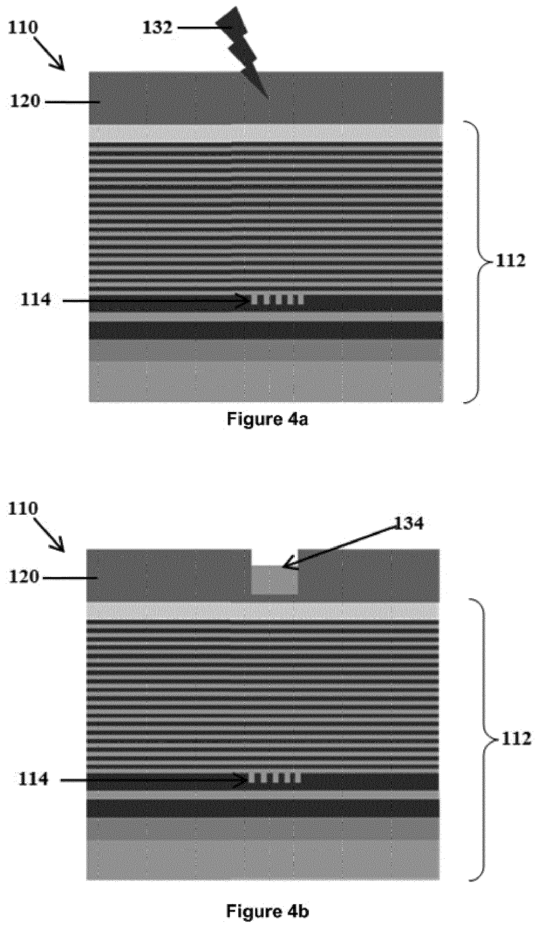

Figures 4a-4c depict part of a substrate 110 that is similar to the substrate 10. In contrast to Figure 3, Figures 4a-4c respectively illustrate three steps of a different alignment procedure for determining alignment between the layers in the substrate 110 and/or for determining any other information from the feature. Elements in Figures 4a-4c that are like or similar to corresponding elements in Figure 3 are indicated by reference signs incremented by 100 compared with Figure 3. The substrate 110 and the process for determining the alignment of layers in the substrate 110 is described in greater detail herein.

In contrast to the procedure in Figure 3 in which: (i) a first alignment mark 18 is etched into the nitride layer 16; and subsequently (ii) a carbon layer 20 is deposited thereon; and then (iii) a further target alignment mark 26 etched into the carbon layer 20, no such etching steps are used in the procedure for Figures 4a-4c. Instead, as illustrated by Figure 4a, a carbon layer (e.g. in the form of a carbon layer 120) is deposited on a nitride layer 116 such that an upper surface 124 of the carbon layer 120 is planar and does not include any alignment marks therein.

A feature, which in this example is in the form of a target alignment mark 114 etched into one of a number of intermediate layers 112, is at least partially obscured by the carbon layer 120, such that an optical signal (not shown in Figure 4a) for determining information about, such as the position of, the target alignment mark 114 is prevented from reaching the target alignment mark 114 due to optical absorption in the carbon layer 120.

An energy delivery system (not shown here but described below) is provided to emit a beam (e.g. of radiation and/or particles), which in this example is in the form of a laser beam 132, for modifying at least one portion 134 of the carbon layer 120 to increase its transparency when the laser beam 132 is incident thereon. As illustrated by Figure 4b, the laser beam 132 has modified the portion 134 resulting in an increase in transparency of the portion 134 compared with the surrounding carbon layer 120. Optionally, a debris removal procedure or etching step may be used to remove debris generated by the laser beam 132 interaction with the portion 134, which may result in the portion 134 having a decreased layer thickness compared with the surrounding carbon layer 120 as shown by Figure 4b.

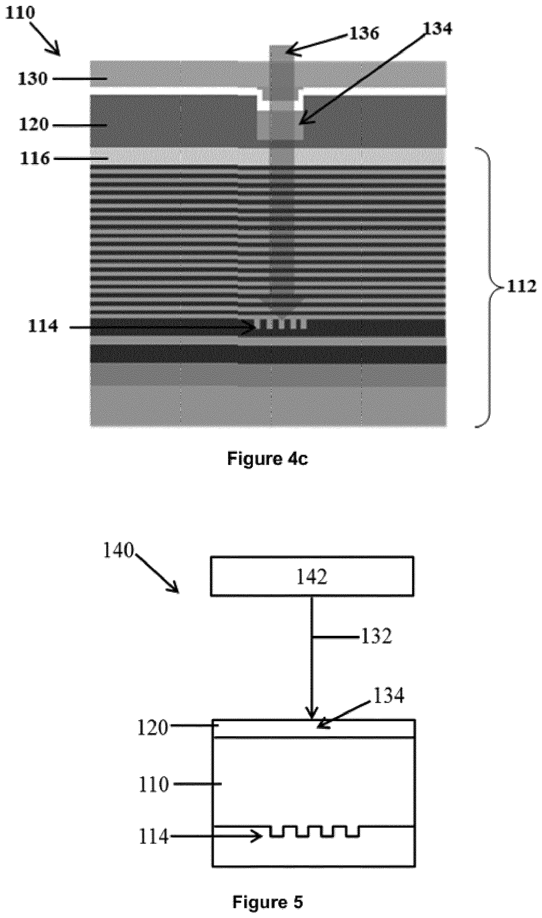

As illustrated by Figure 4c, a resist layer 130 is deposited on the carbon layer 120 including the modified portion 134. An alignment system (not shown) is configured to deliver an optical signal 136 that can propagate through the resist layer 130, through the portion 134, through a nitride layer 116, and through a number of intermediate layers 112 to determine the position of the target alignment mark 114. Due to the increased transparency of the portion 134, the optical signal 136 can at least partly propagate through the portion 134 with less absorption compared with a non-modified area of the carbon layer 120. The optical signal 136 then propagates through the intermediate layers 112 and illuminates the target alignment mark 114. The optical signal 136 may be returned (e.g. reflected, scattered and/or diffracted, or the like) from the target alignment mark 114 such that the returned optical signal (not shown) can propagate back through the portion 134 and the resist layer 130. A substrate alignment system (not shown) includes a radiation sensor (not shown) that is configured to receive optical signal returned through the portion 134. Based on the properties of the received optical signal (e.g. intensity, interference pattern formed, wavelength(s), and/or the like), the alignment determination system can determine the position and/or orientation of the target alignment mark 114 in order to determine whether the substrate 110 is aligned.

In the procedure illustrated by Figures 4a-4c, fewer etching steps are used compared with the procedure illustrated by Figure 3. By enabling alignment or determining information with fewer etching steps, the time taken to determine alignment/the information may be reduced, and hence the cost of manufacturing may be reduced. Further, additional parts of the etching process may be avoided; e.g. refilling the clear out by transparent, etch stopping material may not be needed. Since the position of the target alignment mark 114 can be determined directly it may be possible to increase the accuracy of the overlay between structures in the layers of the substrate 110.

The process for modifying the portion 134 will now be explained in greater detail. Carbon may take several allotropic forms such as amorphous carbon, graphite, diamond-like carbon (DLC) and diamond. The carbon layer 120 used in the manufacture of ICs is generally in the form of amorphous carbon, which has an extinction coefficient 'k' that can be in excess of 0.4 for UV, visible, and IR wavelengths, although it will be appreciated that amorphous carbon may have a different extinction coefficient 'k' for these and other wavelengths. This relatively high extinction coefficient results in the carbon layer 120 being relatively opaque at these and/or some other wavelengths such that an optical signal for determining the position of the target alignment mark 114 cannot penetrate the carbon layer 120, or at least cannot sufficiently penetrate the carbon layer 120 without optical absorption reducing the signal-to-noise ratio of the optical signal returned from the target alignment mark 114 below a threshold level for accurate determination of the alignment.

In the example of Figure 4a, the laser beam 132 interacts with the portion 134 to cause a structural modification of the carbon layer 120 resulting in a phase change of the carbon in the layer 120 that can lead to a reduction of the extinction coefficient thereof. The laser beam 132 delivers a laser pulse to modify the structure of the amorphous carbon towards diamond DLC, which have an extinction coefficient k<0.1 at some wavelengths. This reduced extinction coefficient increases the transparency of the portion 134 to such an extent that the optical signal for determining the position of the target alignment mark 114 can penetrate the carbon layer 120, or at least can sufficiently penetrate the carbon layer 120 without optical absorption reducing the signal-to-noise ratio of the optical signal returned from the target alignment mark 114 below a threshold level for accurate determination of the alignment. The visibility of the target alignment mark 114 through the carbon layer 120 may be increased where the portion 134 has at least partially been modified to form diamond or DLC. By using the laser beam 132 to structurally modify the carbon layer 120 at the portion 134, which is laterally aligned with (e.g. vertically above) the target alignment mark 114, it is possible to make the carbon layer 120 locally more transparent than surrounding areas of the carbon layer 120 to enable alignment directly through the carbon layer 120.

Irradiation by the laser pulses and the associated rapid heating/cooling and/or pressure pulses increase the concentration of sp3 coordinated carbon atoms (which are associated with diamond and DLC) and reduces the concentration of sp2 coordinated carbon atoms (which are associated with amorphous carbon). This structural modification may reduce the concentration and/or mobility of electrons in the valence band of the carbon layer 120, thus reducing the extinction coefficient.

Examples of laser systems for modifying the portion 134 will now be described in greater detail. The peak energy and/or intensity of laser pulses has been associated with generating sufficient heat and/or pressure to cause the conversion of amorphous carbon into carbon and DLC. For example, nanosecond laser pulses at deep ultraviolet (DUV) wavelengths (such as generated by an ArF excimer laser of wavelength 193 nm and pulse duration 20 ns) can be used to melt amorphous carbon and create a highly undercooled state, from which various states of carbon can be created. Such an example is reported in Narayan et al., "Research Update: Direct conversion of amorphous carbou iuto diamoud at ambient pressures aud temperatures in air", APL Materials 3, 100702 (2015), which is incorporated herein by reference. Narayan explains that the quenching from the super undercooled state results in nucleation of nanodiamond. Narayan also found that microdiamonds grow out of a highly undercooled state of carbon, with nanodiamond acting as seed crystals.

A further example laser system for structurally modifying carbon in the form of graphite includes an infrared femtosecond (fs) laser system for exposing polycrystalline graphite to 25 fs 558µJ laser pulses at 4 J/cm² fluence per pulse in a 4 kHz pulse train. Such an example is reported in Maia et al., "Synthesis of diamond-like phase from graphite by ultrafast laser driven dynamical compression", Scientific Reports 5: 11812 (2015), which is incorporated herein by reference. According to Maia, the example laser system synthesized translucent/transparent micrometer-sized structures carrying diamond-like and/or onion-like carbon phases.

Figure 5 illustrates an energy delivery system 140 including an energy source 142 configured to emit radiation and/or particles in a beam, which in this example is in the form of a laser beam 132, for modifying at least one portion 134 of a carbon layer 120 of a substrate 110 to increase the transparency of the portion 134. Modifying the transparency may allow an optical signal to penetrate the modified portion 134 to illuminate a target alignment mark 114 in the substrate 110, as described herein.

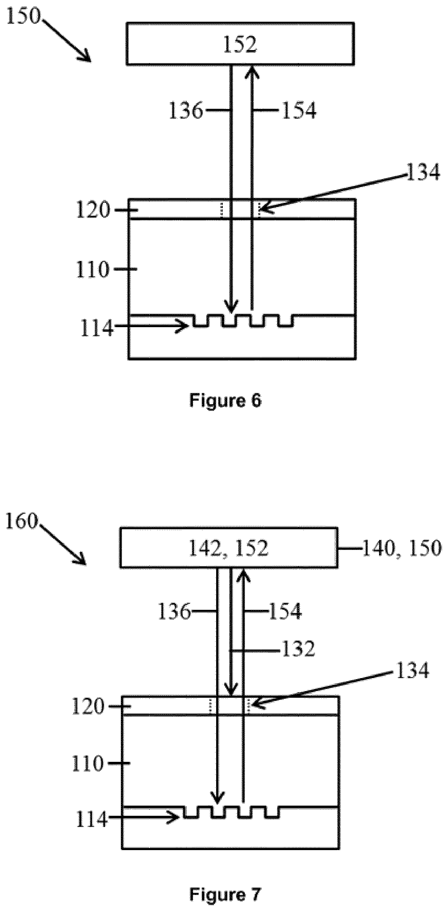

Figure 6 illustrates a substrate alignment system 150, for recovering information such as position, orientation, or the like from the target alignment mark 114. The substrate alignment system 150 includes an optical system 152 for emitting an optical signal 136 for penetrating the modified portion 134 (the boundary of the modified portion in Figure 6 is indicated by dash lines) of the carbon layer 120 to irradiate the target alignment mark 114 such that a return optical signal 154 can be returned from the target alignment mark 114 to the optical system 152. The return optical signal 154 may encode information such as position, orientation, or the like from the target alignment mark 114 in the form of a reflected, scattered and/or diffracted optical signal. The optical system 152 measures the properties of the return optical signal 154 to determine the information relating to the target alignment mark 114 such as the position and/or orientation of the target alignment mark 114 (and/or any other features or alignment marks) so that an alignment of the substrate 110 can be determined. An example of a substrate alignment system 150 and/or the optical system 152 includes an alignment sensor, for example a SMart Alignment Sensor Hybrid (SMASH) sensor, as referred to in U.S. Pat. No. 8,767,183 B2 and described in relation to US. Pat. No. 6,961,116; both of which are incorporated herein by reference. The SMASH sensor includes a self-referencing interferometer with a single detector and four different wavelengths, and extracts the information such as position of the feature using software. It will be appreciated that any appropriate alignment sensor may be used for determining the information. The substrate alignment system 150 and/or the optical system 152 may include a radiation sensor (not shown) for receiving the reflected, scattered and/or diffracted optical signal. The energy delivery system 140, substrate alignment system 150 and/or the optical system 152 may include a Raman detection system (not shown) for measuring a Raman signal produced during modification of the at least one portion 134, or any other appropriate instrument for measuring a property of radiation emitting from the at least one portion 134 before, during or after the modification thereof.

Figure 7 illustrates an apparatus 160 for determining information relating to at least one feature such as a target alignment mark 114 in a substrate 110. The apparatus 160 includes parts from Figures 5 and 6. In the present example, the target alignment mark 114 in the substrate 110 is at least partially obscured by the carbon layer 120, such that an optical signal 136 provided by the optical system 152 for determining the information relating to the target alignment mark 114 is initially prevented from reaching the target alignment mark 114. The apparatus 160 includes the energy delivery system 140 for modifying at least one portion 134 of the carbon layer 120 to increase its transparency. The energy delivery system 140 includes an energy source 142 for emitting a laser beam 132, such that at least part of the optical signal 136 can propagate through the at least one portion 134 of the carbon layer 120. After modification of the at least one portion 134, the visibility of the target alignment mark 114 is increased such that the optical system 152 can measure a property of a return optical signal 154 from the target alignment mark 114 in order to determine information such as position, orientation, or the like, relating to the target alignment mark 114.

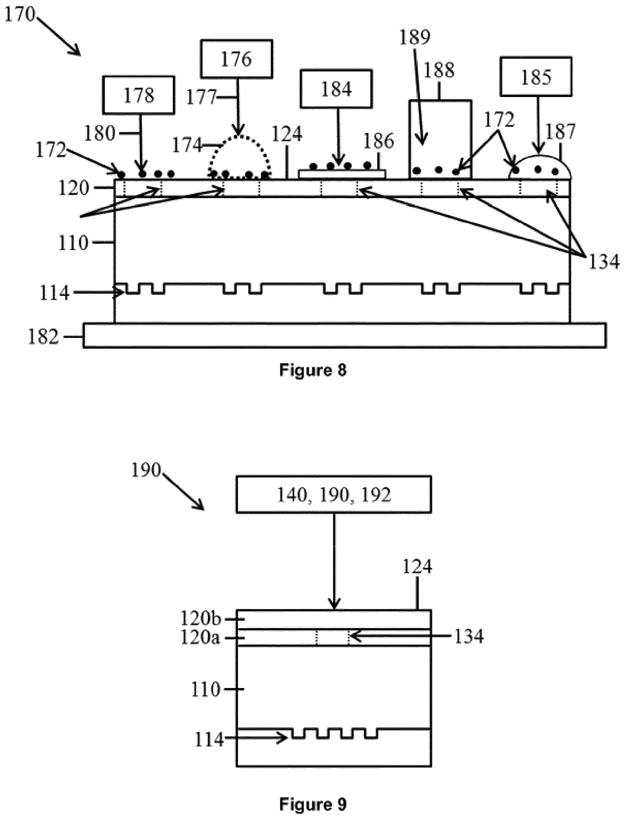

Figure 8 illustrates a debris removal system 170 for removing debris particles 172 from a surface 124 of the carbon layer 120 generated during the modification of the carbon layer 120. The interaction of the laser beam 132 with the carbon layer 120 may result in the formation of an ablation plume 174 above the surface 124, for example, if a parameter (e.g. pulse energy, pulse duration, radiant fluence, or the like) of the laser beam 132 is above an ablation threshold. Figure 8 is merely schematic and illustrates a number of possible debris removal systems 170 that could be used. For convenience only one substrate 110 is illustrated with a modified portion 134 and corresponding target alignment mark 114 provided for each possible debris removal system 170 but it will be appreciated that one or more of the illustrated debris removal systems 170 may be provided for one substrate 110.

Alternatively or in addition, the debris removal system 170 includes a radiation source 176 such as a laser (not shown) for emitting radiation 177 for irradiating the debris particles 172 formed in an ablation plume 174 during modification of the least one portion 134 of the carbon layer 120 for reducing the debris particle 172 size and/or a number of debris particles 172 in the ablation plume 174. The radiation source 176 may be separate to, part of, or the same as, the energy source 142 described previously.

Alternatively or in addition, the debris removal system 170 includes an electric discharger 178 (e.g. in addition to or separate to the radiation source 176) for generating a plasma 180 above the at least one portion 134 of the carbon layer during modification thereof. The plasma 180 captures charged debris particles 172.

Alternatively or in addition, the debris removal system 170 includes a substrate support 182 onto which the substrate 110 may be placed and/or held. The substrate support 182 is moveable and/or inclinable such that debris particles 172 may move away from the carbon layer 120 under force of gravity and/or by using any appropriate tool for removing the debris particles 172. For example, the substrate support 182 may incline the substrate 110 such that a surface 124 of the carbon layer 120 is facing downwards.

Alternatively or in addition, the debris removal system 170 includes a removable layer deposition system 184, for example a spin coater or the like, configured to apply a removable layer 186 to the surface 124 of the carbon layer 120. Debris particles 172 may be collected on the removable layer 186 so as to be removed using any appropriate method at an appropriate time with removal of the removable layer. Alternatively or additionally, the debris removal system 170 includes a removable layer deposition system 184 in the form of a liquid film applicator 185 configured to apply a liquid film 187 or any other form of liquid to the surface 124 of the carbon layer 120 for collecting or recovering debris particles 172 generated by interaction of the beam 132 with the portion 134. Alternatively or additionally, the debris removal system 170 may include a chamber 188 for holding a liquid or gas for at least partially immersing or surrounding the carbon layer 120.

Alternatively or in addition, the debris removal system 170 includes a reactive medium 189, which may be in the form of a gas and/or liquid which may be held in the chamber 188 so as to react the debris particles 172 generated by modification with the reactive medium 189. The products of the reaction, which may be volatile or soluble, may then be removed, e.g. by movement and/or inclination of the substrate support 182, or any other appropriate method such as by providing a fluid or gas flow through the chamber 188 or over the substrate 110, or the like. The debris particles 172 generated may be handled in any appropriate way to remove the debris particles 172 from the carbon layer 172.

Figure 9 illustrates a layer deposition system 190 for depositing at least one layer on the substrate 110. The deposition system 190 may include a spin coater or any other appropriate deposition system. The deposition system 190 may form part of a lithographic apparatus or tool (not shown), or any other appropriate instrument. The layer deposition system 190 may be configured to deposit the carbon layer 120 on the substrate 110 one or more of before, during or after the energy delivery system 140 emits the beam 132 for modifying the portion 134. For example, in the illustrated example, the layer deposition system 190 deposits a first carbon sub-layer 120a on the substrate 110, and then the energy delivery system 140 may be used to modify at least one portion 134 of the carbon layer 120, following which, the layer deposition system 190 may be used deposit a second carbon sub-layer 120b on the substrate 110. Thus, the carbon layer 120 may only be partially modified through its overall thickness, as illustrated by Figure 9. It will be appreciated that any number of carbon layers 120 may be deposited and any of those carbon layers 120 may be modified such that one or more of the carbon layers 120 includes at least one modified portion 134. Each layer of the carbon layers 120 may be regarded as a sub-layer of the overall thickness of the carbon layer 120.

Alternatively or in addition, the deposition system 190 includes or is accompanied by a chemical-mechanical polisher (CMP) 192 for chemical and/or mechanically polishing and/or planarizing the surface 124. The CMP 192 may also be used to remove debris particles 172. The layer deposition system 190 may be used to deposit other layers (e.g. layers having different compositions or materials other than carbon, and/or may be used to deposit dopants such as boron, tungsten, nitrogen and/or any other dopants with the carbon or any other material) on the substrate 110. The layer deposition system 190 may be operable to vary deposition conditions for the creation of at least one seed layer (not shown) in the carbon layer 120 (e.g. on the surface 124 of the carbon layer 124). The seed layer may include sp3-coordinated carbon for acting as seed layer for nanodiamond nucleation and/or diamond-like carbon, DLC. For example, the layer deposition system 190 may deposit an initial carbon layer 120 on the substrate 110, following which the layer deposition system 190 may deposit a seed carbon layer 120 including sp3-coordinated carbon or the like, on the initial carbon layer 120. The seed carbon layer 120 may be provided by any appropriate method, for example, via a vapour deposition system or by a spin coater, or the like.

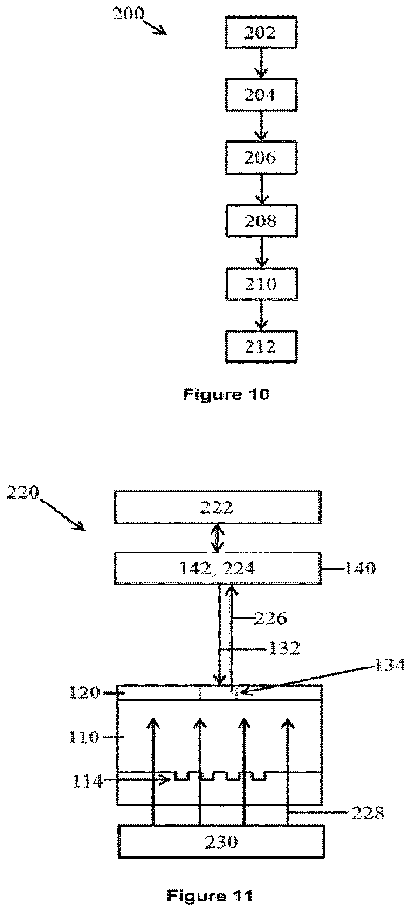

Figure 10 illustrates parts of a method 200 for determining information relating to at least one feature such as a target alignment mark 114 in a semiconductor device substrate 110, wherein the target alignment mark 114 is at least partially obscured by a carbon layer 120, such that an optical signal 136 for determining information relating to the target alignment mark 114 is prevented from reaching the target alignment mark 114. The method 200 includes: a first step 202 including emitting, by an energy delivery system 140, radiation and/or particles in a beam 132 for modifying at least one portion 134 of the carbon layer 120 to increase its transparency when the beam 132 is incident thereon. In a second step 204, the radiation and/or particles in the beam 132 are incident on the at least one portion 134 of the carbon layer 120 such that it is modified and at least part of the optical signal 136 for determining the information relating to the target alignment mark 114 can propagate through the at least one portion 134 of the carbon layer 120. In a third step 206, an optical system 152 emits the optical signal 136 for determining the information relating to the target alignment mark 114. In a fourth step 208, the optical signal 136 penetrates the modified at least one portion 134 and at least partially propagates through to irradiate the target alignment mark 114. In a fifth step 210, information relating to the target alignment mark 114 is returned to the optical system 152 through the at least one portion 134 (e.g. the optical signal 136 may be reflected, scattered and/or diffracted by the target alignment mark 114 in the form of a return optical signal 154). In a sixth step 212, the substrate alignment system 150 may use at least one property (e.g. intensity, wavelength(s), interference pattern, and/or the like) of the returned optical signal 152 to determine information (e.g. position, orientation, or the like) relating to the target alignment mark 114.

Figure 11 illustrates a feedback control system 220 including a control unit 222 configured to determine one or more parameters, such as dimensions, transparency, or the like of the at least one portion 134 of the carbon layer 120 and to control the energy delivery system 140 based on the one or more parameters. Alternatively or in addition, the feedback control system 220 includes a radiation sensor 224, which is configured to receive radiation 226 from the at least one portion 134 of the carbon layer 120 (e.g. which may be emitted during or after modification of the portion 134 by the laser beam 132). The feedback control system 220 is configured to determine the one or more parameters of the at least one portion 134 of the carbon layer 120 based on the received radiation 226. Further, the feedback control system 220 may control, via the control unit 222, the amount of energy being deposited by the energy delivery system 140 (e.g. to control the degree of modification of the portion 134). The received radiation 226 may be derived from the energy source 142 (e.g. reflected, scattered, diffracted or the like from the portion 134), or any other source of radiation and/or particles. Alternatively or in addition, the received radiation 226 includes radiation (and/or particles) 228 produced by a further radiation source such as a backlight 230 that has propagated through the at least one portion 134 of the carbon layer 120 and that has been emitted from a radiation source 226 configured to backlight the substrate 110. The carbon layer 120 may at least partially block the radiation 228 such that upon the portion 134 being modified, the radiation sensor 224 may detect an increase in the level of the radiation 228 (e.g. due to the increase in the transparency thereof) and prompt, via the control unit 222, the energy delivery system 140 to control, reduce or stop the amount of radiation and/or particles being used to modify the portion 134.

It will be appreciated that any appropriate energy delivery system 140 for providing at least one laser beam 132 could be used for modifying the at least one portion 134. For example, the energy source 142 could include at least one: laser; pulsed laser for emitting at least one or a series of laser pulses; a continuous wave (CW) laser, and/or the like. Alternatively or additionally, the energy source 142 could be configured to emit a beam comprising particles for pulsed heating of the at least one portion 134. For example, the energy delivery system 140 could be configured to emit one or more of: an electron beam; an ion beam; a neutral beam; an extreme ultraviolet (EUV) beam in a range from 4 to 20 nm; and a beam comprising radiation having wavelengths in a range from 20 to 100 nm. It will be appreciated that the energy delivery system 140 may be configured to emit one or both of: radiation; and particles for modifying the at least one portion 134.

Figures 5 and 6 illustrate the energy delivery system 140 and substrate alignment system 150 as separate tools. Figure 7 illustrate the apparatus 160 which includes features from both the energy delivery system 140 and the substrate alignment system 150. It will be appreciated that the energy delivery system 140 can be used to modify the carbon layer 120 in a first step, and the substrate alignment system 150 can be used to determine information in relation to the target alignment mark 114 in a second step. The first and second steps may be performed within the same or separate tools. For example, the substrate 110 may be moved between different tools between the steps. Alternatively, the substrate 110 may remain in situ during the procedure for determining information in relation to the target alignment mark 114. The apparatus 160 may include one or more tools, which may be separate or integral with each other.

Although the examples described herein refer to the modification of a carbon layer 120, it will be appreciated that other layers may be modified. For example, the energy deposition system 140 may be operable to modify a portion 134 of any layer including an appropriate element, compound or composition. The layer may include pure carbon or doped carbon. For example, the layer may include dopants such as tungsten, boron, nitrogen and/or the like. It will be appreciated that any appropriate dopant or impurity may be deposited along with the carbon. While the present disclosure refers to the layer comprising carbon, it will be appreciated that the modification of a layer not comprising carbon may be contemplated by the present disclosure. The layer may function to provide a hard mask and any appropriate material may be used to provide this functionality.

Although specific reference may be made in this text to the use of lithographic apparatus in the manufacture of ICs, it should be understood that the lithographic apparatus described herein may have other applications. Possible other applications include the manufacture of integrated optical systems, guidance and detection patterns for magnetic domain memories, flat-panel displays, liquid-crystal displays (LCDs), thin-film magnetic heads, etc.

In an example, the present disclosure may form part of a mask inspection apparatus. The mask inspection apparatus may use EUV radiation to illuminate a mask and use an imaging sensor to monitor radiation reflected from the mask. Images received by the imaging sensor are used to determine whether or not defects are present in the mask. The mask inspection apparatus may include optics (e.g. mirrors) configured to receive EUV radiation from an EUV radiation source and form it into a radiation beam to be directed at a mask. The mask inspection apparatus may further include optics (e.g. mirrors) configured to collect EUV radiation reflected from the mask and form an image of the mask at the imaging sensor. The mask inspection apparatus may include a processor configured to analyse the image of the mask at the imaging sensor, and to determine from that analysis whether any defects are present on the mask. The processor may further be configured to determine whether a detected mask defect will cause an unacceptable defect in images projected onto a substrate when the mask is used by a lithographic apparatus.

In an example, the present disclosure may form part of a metrology apparatus. The metrology apparatus may be used to measure alignment of a projected pattern formed in resist on a substrate relative to a pattern already present on the substrate. This measurement of relative alignment may be referred to as overlay. The metrology apparatus may for example be located immediately adjacent to a lithographic apparatus and may be used to measure the overlay before the substrate (and the resist) has been processed.

Although specific reference may be made in this text to examples of the present disclosure in the context of a lithographic apparatus, examples of the present disclosure may be used in other apparatus. Examples of the present disclosure may form part of a mask inspection apparatus, a metrology apparatus, a lithography scanner, a lithography tracking system, a substrate or wafer track tool, a deposition tool, or any apparatus that measures or processes an object such as a wafer (or other substrate) or mask (or other patterning device). These apparatus may be generally referred to as lithographic tools. Such a lithographic tool may use vacuum conditions or ambient (non-vacuum) conditions.

Although specific reference may have been made above to the use of examples of the present disclosure in the context of optical lithography, it will be appreciated that the present disclosure, where the context allows, is not limited to optical lithography and may be used in other applications, for example imprint lithography.

A computer program may be configured to provide any of the above described methods. The computer program may be provided on a computer readable medium. The computer program may be a computer program product. The product may comprise a non-transitory computer usable storage medium. The computer program product may have computer-readable program code embodied in the medium configured to perform the method. The computer program product may be configured to cause at least one processor to perform some or all of the method.

Various methods and apparatus are described herein with reference to block diagrams or flowchart illustrations of computer-implemented methods, apparatus (systems and/or devices) and/or computer program products. It is understood that a block of the block diagrams and/or flowchart illustrations, and combinations of blocks in the block diagrams and/or flowchart illustrations, can be implemented by computer program instructions that are performed by one or more computer circuits. These computer program instructions may be provided to a processor circuit of a general purpose computer circuit, special purpose computer circuit, and/or other programmable data processing circuit to produce a machine, such that the instructions, which execute via the processor of the computer and/or other programmable data processing apparatus, transform and control transistors, values stored in memory locations, and other hardware components within such circuitry to implement the functions/acts specified in the block diagrams and/or flowchart block or blocks, and thereby create means (functionality) and/or structure for implementing the functions/acts specified in the block diagrams and/or flowchart block(s).

Further embodiments of the inventions are disclosed in the list of numbered embodiments below:
1. An apparatus for determining information relating to at least one feature in a semiconductor device substrate, wherein the at least one feature is at least partially obscured by a layer comprising carbon, such that an optical signal for determining the information relating to the at least one feature is prevented from reaching the feature, wherein the apparatus comprises:
   an energy delivery system configured to emit radiation and/or particles for modifying at least one portion of the layer to increase its transparency when or after the radiation and/or particles are incident thereon, such that at least part of the optical signal can propagate through the at least one portion of the layer for determining the information relating to the at least one feature.
2. The apparatus of embodiment 1, wherein the energy delivery system is configured to emit a beam for modifying the at least one portion of the layer by reducing the extinction coefficient of the carbon at the at least one portion of the layer.
3. The apparatus of embodiment 1 or 2, wherein the energy delivery system is configured to emit a beam for modifying the at least one portion of the layer by causing a phase change in the carbon and/or causing an increase in the concentration of carbon atoms at the at least one portion of the layer.
4. The apparatus of embodiment 3, wherein the phase change modifies the carbon at the at least one portion of the layer such that the carbon forms at least one of: diamond; and diamond-like carbon.
5. The apparatus of any preceding embodiment, wherein the energy delivery system comprises at least one of: at least one laser for emitting the radiation and/or at least one source of a focused beam of energetic particles.
6. The apparatus of embodiment 5, wherein the at least one laser comprises a pulsed laser source configured to emit at a series of laser pulses.
7. The apparatus of embodiment 5 or 6, wherein the at least one laser is configured to emit radiation having at least one wavelength in a range from 4 nm to 3 µm.
8. The apparatus of any of embodiments 5 to 7, wherein the at least one laser is configured to emit one or more of:
   visible and/or infrared laser pulses with a pulse duration in a range from 5 fs to 500 ps; ultraviolet laser pulses with a pulse duration in the range 1 ps to 500 ns; and
   soft X-ray to DUV laser pulses with a pulse duration in the range 1 fs to 100 ns.
9. The apparatus of any of embodiments 5 to 8, wherein the at least one laser is configured to emit an initial pulse train comprising at least one laser pulse of a first pulse duration,
   and further configured to emit a subsequent pulse train comprising at least one laser pulse of a shorter, second pulse duration.
10. The apparatus of any of embodiments 5 to 9, wherein the at least one laser is configured to emit radiation having a peak radiant fluence or intensity of radiation below an ablation threshold for the layer.
11. The apparatus of any of embodiments 5 to 10, wherein the at least one laser is configured to emit at least one of: a linear polarized radiation; non-linear polarized radiation; elliptical polarized radiation; and spiral polarized radiation.
12. The apparatus of embodiment 11, wherein the at least one laser is configured to emit a sequence of laser pulses, each laser pulse having one of: linear polarization; circular polarization; elliptical polarization; and spiral polarization; and/or a sequence of laser pulses with some pulses within the train having a different polarization to other pulses within the train.
13. The apparatus of any preceding embodiment, wherein the energy delivery system is configured to emit radiation and/or particles for pulsed heating of the at least one portion of the layer.
14. The apparatus of embodiment 13, wherein the energy delivery system is configured to emit one or more of: an electron beam; an ion beam; a neutral beam; an extreme ultraviolet (EUV) beam in a range from 5 to 20 nm; and a beam comprising radiation having wavelengths in a range from 20 to 100 nm.
15. The apparatus of any preceding embodiment, further comprising a feedback control system configured to determine one or more parameters of the at least one portion of the layer and to control the energy delivery system based on the one or more parameters.
16. The apparatus of embodiment 15, wherein the feedback control system comprises a radiation sensor configured to receive radiation from the at least one portion of the layer,
   and wherein the feedback control system is configured to determine the one or more parameters of the at least one portion of the layer based on the received radiation.
17. The apparatus of embodiment 16, wherein the received radiation comprises one or more of:
   the radiation from the energy delivery system reflected or scattered from the at least one portion of the layer;
   radiation that has propagated through the at least one portion of the layer and that has been emitted from a radiation source configured to backlight the semiconductor device substrate;
   radiation excited in the portion of the layer by radiation and/or particles from the energy delivery system; and
   radiation from an auxiliary light source, directed to and reflected and/or scattered from a spot that overlaps substantially with the portion of the layer that is modified by the energy delivery system.
18. The apparatus of any preceding embodiment, wherein the energy delivery system is configured to emit radiation and/or particles for modifying the transparency of the at least one portion of the layer to a depth less than the overall thickness of the layer.
19. The apparatus of any preceding embodiment, comprising a layer deposition system for depositing the layer on the substrate.
20. The apparatus of embodiment 19, wherein the layer deposition system is configured to deposit a first sub-layer of the layer on the substrate, and wherein the energy delivery system is operable to modify at least one portion in the first sub-layer.
21. The apparatus of embodiment 20, wherein the layer deposition system is configured to deposit a second sub-layer of the layer on the first sub-layer after modification of the at least one portion of the first sub-layer.
22. The apparatus of any of embodiments 19 to 21, wherein the layer deposition system is operable to vary deposition conditions for the creation of at least one seed sub-layer in the layer, the seed sub-layer comprising sp3-coordinated carbon for acting as seed for nanodiamond nucleation and/or diamond-like carbon, DLC.
23. The apparatus of embodiment 22, wherein the layer deposition system is configured to deposit the at least one seed sub-layer at an upper surface of the layer.
24. The apparatus of any preceding embodiment, comprising a debris removal system for removing from a surface of the layer debris particles generated during the modification.
25. The apparatus of embodiment 24, wherein the debris removal system comprises a radiation source for emitting radiation for irradiating the debris particles formed in an ablation plume during modification of the least one portion of the layer for reducing the debris particle size and/or a number of debris particles in the ablation plume.
26. The apparatus of embodiment 24 or 25 wherein the debris removal system comprises an electric discharger for generating a plasma above the at least one portion of the layer during modification thereof, the plasma capturing charged debris particles.
27. The apparatus of any of embodiments 24 to 26, wherein the debris removal system is configured to incline the semiconductor device substrate, such that the debris particles move away from the layer under force of gravity.
28. The apparatus of any of embodiments 24 to 27, wherein the debris removal system is configured to apply a removable layer to a surface of the layer, wherein the debris particles are collected on the removable layer, the debris removal system being further configured to remove the removable layer after modification of the at least one portion of the layer.
29. The apparatus of embodiment 28, wherein the debris removal system is configured to remove the removable layer at the location of the at least one portion of the layer before the energy delivery system emits the radiation and/or particles.
30. The apparatus of any of embodiments 24 to 29, wherein the debris removal system is configured to provide a reactive medium in proximity to the at least one portion of the layer, such that only the products of reaction of material within the ablation plume are substantially volatile or soluble.
31. The apparatus of any preceding embodiment, further comprising a chamber configured to hold a liquid, and wherein the semiconductor device substrate is at least partially immersed in the liquid at least during emission of the radiation and/or particles by the energy delivery system.
32. The apparatus of any preceding embodiment, further comprising a liquid film applicator configured to apply a liquid film to a surface of the layer before the energy delivery system emits the radiation and/or particles.
33. The apparatus of any preceding embodiment, comprising an optical system configured to transmit an optical signal through the at least one portion of the layer for determining information relating to the at least one feature.
34. The apparatus of any preceding embodiment, comprising a substrate alignment system for determining information relating to the at least one feature based on a return optical signal received through the at least one portion of the layer.
35. The apparatus of embodiment 34, wherein the substrate alignment system is configured to determine at least one of: the presence; position and orientation of the at least one feature in order to determine whether the substrate is aligned.
36. The apparatus of embodiment 35, wherein the substrate alignment system is configured to control the relative positioning between the substrate and a lithography apparatus or lithographic tool to align the substrate therein.
37. The apparatus of any preceding embodiment, wherein the feature comprises an alignment or overlay mark.
38. The apparatus of any preceding embodiment, wherein the modified layer comprises at least 20% carbon, and optionally comprises at least 50% carbon.
39. A lithography apparatus comprising the apparatus of any one of embodiments 1 to 38.
40. A lithographic tool comprising the apparatus of any one of embodiments 1 to 38.
41. A method for determining information relating to at least one feature in a semiconductor device substrate, wherein the at least one feature is at least partially obscured by a layer comprising carbon, such that an optical signal for determining information relating to the at least one feature is prevented from reaching the feature, wherein the method comprises:
   emitting, by an energy delivery system, radiation and/or particles for modifying at least one portion of the layer to increase its transparency when or after the radiation and/or particles is incident thereon, such that at least part of the optical signal for determining the information relating to the at least one feature can propagate through the at least one portion of the layer for determining the information relating to the at least one feature.
42. A computer program comprising instructions which, when executed on at least one processor, cause the at least one processor to control an apparatus to carry out the method according to embodiment 41.
43. A carrier containing the computer program of embodiment 42, wherein the carrier is one of an electronic signal, optical signal, radio signal, or non-transitory computer readable storage medium.

Computer program instructions may also be stored in a computer-readable medium that can direct a computer or other programmable data processing apparatus to function in a particular manner, such that the instructions stored in the computer-readable medium produce an article of manufacture including instructions which implement the functions/acts specified in the block diagrams and/or flowchart block or blocks.

A tangible, non-transitory computer-readable medium may include an electronic, magnetic, optical, electromagnetic, or semiconductor data storage system, apparatus, or device. More specific examples of the computer-readable medium would include the following: a portable computer diskette, a random access memory (RAM) circuit, a read-only memory (ROM) circuit, an erasable programmable read-only memory (EPROM or Flash memory) circuit, a portable compact disc read-only memory (CD-ROM), and a portable digital video disc read-only memory (DVD/Blu-ray).

The computer program instructions may also be loaded onto a computer and/or other programmable data processing apparatus to cause a series of operational steps to be performed on the computer and/or other programmable apparatus to produce a computer-implemented process such that the instructions which execute on the computer or other programmable apparatus provide steps for implementing the functions/acts specified in the block diagrams and/or flowchart block or blocks.

Accordingly, the invention may be embodied in hardware and/or in software (including firmware, resident software, micro-code, etc.) that runs on a processor, which may collectively be referred to as "circuitry," "a module" or variants thereof.

It should also be noted that in some alternate implementations, the functions/acts noted in the blocks may occur out of the order noted in the flowcharts. For example, two blocks shown in succession may in fact be executed substantially concurrently or the blocks may sometimes be executed in the reverse order, depending upon the functionality/acts involved. Moreover, the functionality of a given block of the flowcharts and/or block diagrams may be separated into multiple blocks and/or the functionality of two or more blocks of the flowcharts and/or block diagrams may be at least partially integrated. Finally, other blocks may be added/inserted between the blocks that are illustrated.

While specific examples of the present disclosure have been described above, it will be appreciated that the present disclosure may be practiced otherwise than as described. The descriptions above are intended to be illustrative, not limiting. Thus it will be apparent to one skilled in the art that modifications may be made to the present disclosure as described without departing from the scope of the claims set out below.

## Claims

1. An apparatus for determining information relating to at least one feature in a semiconductor device substrate, wherein the at least one feature is at least partially obscured by a layer comprising carbon, such that an optical signal for determining the information relating to the at least one feature is prevented from reaching the feature, wherein the apparatus comprises:
an energy delivery system configured to emit radiation and/or particles for modifying at least one portion of the layer to increase its transparency when or after the radiation and/or particles are incident thereon, such that at least part of the optical signal can propagate through the at least one portion of the layer for determining the information relating to the at least one feature.

2. The apparatus of claim 1, wherein the energy delivery system is configured to emit a beam for modifying the at least one portion of the layer by reducing the extinction coefficient of the carbon at the at least one portion of the layer.

3. The apparatus of claim 1 or 2, wherein the energy delivery system is configured to emit a beam for modifying the at least one portion of the layer by causing a phase change in the carbon and/or causing an increase in the concentration of carbon atoms at the at least one portion of the layer.

4. The apparatus of claim 3, wherein the phase change modifies the carbon at the at least one portion of the layer such that the carbon forms at least one of: diamond; and diamond-like carbon.

5. The apparatus of any preceding claim, wherein the energy delivery system comprises at least one of: at least one laser for emitting the radiation and/or at least one source of a focused beam of energetic particles.

6. The apparatus of claim 5, wherein the at least one laser comprises a pulsed laser source configured to emit at a series of laser pulses.

7. The apparatus of claim 5 or 6, wherein the at least one laser is configured to emit radiation having at least one wavelength in a range from 4 nm to 3 µm.

8. The apparatus of any of claims 5 to 7, wherein the at least one laser is configured to emit one or more of:
visible and/or infrared laser pulses with a pulse duration in a range from 5 fs to 500 ps;
ultraviolet laser pulses with a pulse duration in the range 1 ps to 500 ns; and
soft X-ray to DUV laser pulses with a pulse duration in the range 1 fs to 100 ns.

9. The apparatus of any of claims 5 to 8, wherein the at least one laser is configured to emit an initial pulse train comprising at least one laser pulse of a first pulse duration,
and further configured to emit a subsequent pulse train comprising at least one laser pulse of a shorter, second pulse duration.

10. The apparatus of any of claims 5 to 9, wherein the at least one laser is configured to emit radiation having a peak radiant fluence or intensity of radiation below an ablation threshold for the layer.

11. The apparatus of any of claims 5 to 10, wherein the at least one laser is configured to emit at least one of: a linear polarized radiation; non-linear polarized radiation; elliptical polarized radiation; and spiral polarized radiation.

12. The apparatus of claim 11, wherein the at least one laser is configured to emit a sequence of laser pulses, each laser pulse having one of: linear polarization; circular polarization; elliptical polarization; and spiral polarization; and/or a sequence of laser pulses with some pulses within the train having a different polarization to other pulses within the train.

13. The apparatus of any preceding claim, wherein the energy delivery system is configured to emit radiation and/or particles for pulsed heating of the at least one portion of the layer.

14. The apparatus of claim 13, wherein the energy delivery system is configured to emit one or more of: an electron beam; an ion beam; a neutral beam; an extreme ultraviolet (EUV) beam in a range from 5 to 20 nm; and a beam comprising radiation having wavelengths in a range from 20 to 100 nm.

15. The apparatus of any preceding claim, further comprising a feedback control system configured to determine one or more parameters of the at least one portion of the layer and to control the energy delivery system based on the one or more parameters.
